# EUROPEAN PATENT APPLICATION

(11) **EP 4 704 142 A1**
(43) Date of publication of application: **04.03.2026**
(21) Application number: 24797108.8
(22) Date of filing: 24.04.2024
(51) Int. Cl.: H01L 21/52, H01L 21/60

(54) **LAMINATE, METHOD FOR MANUFACTURING LAMINATE, AND METHOD FOR MANUFACTURING SEMICONDUCTOR DEVICE**

(30) Priority: 26.04.2023 JP 2023072581
(71) Applicant: Toray Industries, Inc., Tokyo 103-8666 (JP)
(72) Inventor: FUJIWARA, Takenori, Otsu-shi, Shiga 520-8558 (JP); ARIMOTO, Yukari, Otsu-shi, Shiga 520-8558 (JP); AOSHIMA, Kenta, Otsu-shi, Shiga 520-8558 (JP)
(74) Representative: Kador & Partner Part mbB
(86) International application number: PCT/JP2024/016178
(87) International publication number: WO 2024/225363

(57) **Abstract**

The present invention relates to a laminate in which a laser-absorbing temporary adhesive layer 1, a protective layer 1, and a semiconductor layer 1 are laminated in this order on a laser-transmissive substrate 1.

## Description

### TECHNICAL FIELD

The present invention relates to a laminate, a method for producing a laminate, and a method for producing a semiconductor device using a laminate. More specifically, the present invention relates to a laminate including a laser-absorbing temporary adhesive layer suitable for use in mounting a semiconductor element by laser transfer, a laminate including a pressure-sensitive adhesive layer which is an adherend of a semiconductor element after laser transfer, a method for producing a laminate, and a method for producing a semiconductor device in which a semiconductor element is mounted by using a laminate.

### BACKGROUND ART

In general, a semiconductor element to be incorporated into a semiconductor device is transferred and mounted on a circuit substrate or the like by a pick-and-place method using a flip chip bonder or the like. In recent years, semiconductor devices have been improved in performance and reduced in size, and accordingly, semiconductor elements to be incorporated into the semiconductor devices have also been reduced in size and thickness, and the number of semiconductor elements to be mounted has increased.

In addition, in recent years, in devices using Group III-V compound semiconductor chips, such as gallium arsenide or indium phosphide, heat generated at the time of driving the devices has become a problem. Therefore, in order to improve a heat dissipation property, studies have been made to directly bond chips to substrates having different heat dissipation properties, such as a silicon substrate, to promote the heat dissipation property of the devices and improve a driving property (Patent Literature 1). In silicon photonics, a Group III-V compound semiconductor laser chip is directly bonded to a SOI (silicon on insulator) wafer on which an optical waveguide is formed to realize size reduction and cost reduction by integration (Patent Literature 2, and Non Patent Literatures 1, 2, and 3).

Under such circumstances, as a technique for treating a large number of semiconductor elements at one time, a chip transfer and mounting method using a stamp method is also implemented. According to this method, by mounting a pattern sheet made of a pressure-sensitive adhesive resin such as a silicone-based rubber material or a polydimethylsiloxane resin on a stamp head, it is possible to transfer and mount a large number of semiconductor elements at one time (Patent Literatures 3 and 4 and Non Patent Literatures 2 and 3).

On the other hand, such a pressure-sensitive adhesive resin is also used as a pressure-sensitive adhesive layer for bonding substrates to each other, in addition to being used in the transferring and mounting technique for semiconductor elements. For example, in the field of power semiconductors, in order to prevent warpage and cracks of a device substrate during a thinning treatment for the substrate, the device substrate is passed through steps after being bonded to a support substrate. It is disclosed that, at this time, by bonding the support substrate by using a polyimide copolymer having siloxanes with different chain lengths in the structure as a pressure-sensitive adhesive layer, it is possible to prevent generation of voids in a high temperature treatment step such as ion implantation essential during the power semiconductor production, and further, it is possible to easily remove the polyimide copolymer with a solvent after the treatment (Patent Literature 5). In addition, it is also disclosed that chemical resistance is improved by adding a crosslinking agent to the polyimide copolymer having siloxanes in the structure, and the polyimide copolymer can be used as a copper-clad substrate for TAB (tape automated bonding) (Patent Literature 6).

### CITATION LIST

### PATENT LITERATURE

Patent Literature 1: JP2006-108556A
Patent Literature 2: JP2017-500735A
Patent Literature 3: JP2015-140372A
Patent Literature 4: JP2020-129638A
Patent Literature 5: WO2016/021646
Patent Literature 6: JPH10-226778A

### NON-PATENT LITERATURE

Non Patent Literature 1: Alexander W. Fang et al., Electrically pumped hybrid AlGaInAs-silicon evanescent laser, OPTICS EXPRESS, 2006, Vol. 14, No. 20, p9203
Non Patent Literature 2: Jing Zhang et al., III-V-on-Si photonic integrated circuits realized using micro-transfer-printing, APL Photon., 2019, 4, 110803
Non Patent Literature 3: LUO et al., Wafer-scale dies-transfer bonding technology for hybrid III/V-on-silicon photonic integrated circuit, IEEE JOURNAL OF SELECTED TOPICS IN QUANTUM ELECTRONICS, 2016, Vol. 22, No. 6, 8200612

### SUMMARY OF INVENTION

### TECHNICAL PROBLEM

In the techniques in Patent Literatures 1 and 2, since the semiconductor element and the substrate for heat dissipation are directly bonded to each other, it is necessary to apply a high temperature and pressure for bonding. Therefore, semiconductor elements need to be transferred and mounted one by one (transferring and mounting speed: 0.1 to 1 piece/second) by using a flip chip (hereinafter also referred to as "FC") bonder capable of high temperature bonding, and there is a problem that the transfer and mounting step takes a long time. In addition, in Non Patent Literatures 1 and 2, wafers are collectively subjected to the high temperature bonding, and although the step is shortened in time, it is necessary to transfer and mount semiconductor elements one by one. In both Non Patent Literatures 1 and 2, it is desired to transfer an epitaxially grown thin film crystal, but there is a problem that the thin film crystal is brittle and damaged during transportation. Therefore, a step of transporting the thin film crystal together with a substrate and then peeling off the substrate is required.

On the other hand, in the techniques in Patent Literatures 3 and 4 and Non Patent Literature 2, a large number of semiconductor elements can be transferred and mounted at one time, but since a size of a stamp depends on a wafer size, the number of semiconductor elements for simultaneous transfer is limited. In addition, it is necessary to prepare a stamp according to a design of the circuit substrate each time, and there is a problem that defective chips are also transferred at the same time. Since the resin used for the stamp head has insufficient heat resistance, there is also a problem that it cannot be applied to a technique requiring mounting at a high temperature such as direct bonding.

In addition, the polyimide copolymer presented in Patent Literatures 5 and 6 has high heat resistance, but has very high adhesiveness since it is specialized in process passability after adhering to a substrate or a copper foil, and when it is intended to be applied to a transfer application for a minute device such as a semiconductor element, the application is difficult, due to the difficulty of the transfer itself and a large amount of residue caused by the adhesive remaining on the chip surface after transfer.

That is, there are problems that a process time in the FC bonder mounting for the semiconductor chip is long, and damages occur during transferring and mounting of the thin film semiconductor chip, and inability to avoid both problems is a further problem.

### SOLUTION TO PROBLEM

The present inventors have found that the above problems can be solved by producing a semiconductor device by a laser lift-off (LLO) technique using a laminate 1 in which a laser-absorbing temporary adhesive layer 1, a protective layer 1, and a semiconductor layer 1 are laminated in this order on a laser-transmitting substrate 1 and a laminate 2 in which a pressure-sensitive adhesive layer is laminated on a support substrate 2.

In order to solve the above problems, the present invention is characterized by the following (1) to (14).
(1) A laminate including: a laser-transmitting substrate 1; and a laser-absorbing temporary adhesive layer 1, a protective layer 1, and a semiconductor layer 1 laminated in this order on the laser-transmitting substrate 1.
(2) The laminate according to the above (1), in which the semiconductor layer 1 is a compound semiconductor.
(3) The laminate according to the above (2), in which the compound semiconductor is AlGaInAs, InGaAs, InP, InGaAsP, AlAs, InAs, GaAs, AlN, AlP, GaN, InN, or SiC.
(4) The laminate according to any one of the above (1) to (3), in which the protective layer 1 is at least one of an oxide film and a nitride film.
(5) The laminate according to the above (4), in which the protective layer 1 contains SiO₂.
(6) A method for producing a laminate, successively including:
   a step (I) of using a laminate 1, in which a laser-absorbing temporary adhesive layer 1, a protective layer 1, and a semiconductor layer 1 are laminated in this order on a laser-transmitting substrate 1, and a laminate 2, in which a pressure-sensitive adhesive layer is laminated on a support substrate 2, to cause a surface of the laminate 1 on a semiconductor layer 1 side and a surface of the laminate 2 on a pressure-sensitive adhesive layer side to face each other; and
   a step (II) of irradiating the laser-absorbing temporary adhesive layer 1 with a laser from a surface side of the laminate 1 opposite to the surface thereof on the semiconductor layer 1 side while transmitting the laser through the laser-transmitting substrate 1, and transferring a structure in which the protective layer 1 and the semiconductor layer 1 are laminated to the laminate 2 to form a laminate 3 in which the pressure-sensitive adhesive layer, the semiconductor layer 1, and the protective layer 1 are laminated in this order on the support substrate 2.
(7) The method for producing a laminate according to the above (6), in which
   in the step (II),
   the structure 1 is a structure 2 in which the laser-absorbing temporary adhesive layer 1, the protective layer 1, and the semiconductor layer 1 are laminated, and
   the laminate 3 is a laminate 4 in which the pressure-sensitive adhesive layer, the semiconductor layer 1, the protective layer 1, and the laser-absorbing temporary adhesive layer 1 are laminated in this order on the support substrate 2.
(8) The method for producing a laminate according to the above (6), further including:
   a step (III) of removing a part of the pressure-sensitive adhesive layer in the laminate 3 and patterning the pressure-sensitive adhesive layer.
(9) The method for producing a laminate according to the above (7), further including:
   a step (III') of removing a part of the pressure-sensitive adhesive layer in the laminate 4 and patterning the pressure-sensitive adhesive layer.
(10) The method for producing a laminate according to the above (8), in which the step (III) includes a step (III-A) of performing dry-etching or wet-etching on the pressure-sensitive adhesive layer in the laminate 3 by using the semiconductor layer 1 or the protective layer 1 in the laminate 3 as a mask.
(11) The method for producing a laminate according to the above (9), in which the step (III') includes a step (III'-A) of performing dry-etching or wet-etching on the pressure-sensitive adhesive layer in the laminate 4 by using the semiconductor layer 1, the protective layer 1, or the laser-absorbing temporary adhesive layer 1 in the laminate 4 as a mask.
(12) The method for producing a laminate according to the above (6), (8), or (10), further including:
   a step (IV) of removing the protective layer 1 from the laminate 3.
(13) The method for producing a laminate according to the above (7), (9), or (11), further including:
   a step (IV') of removing the laser-absorbing temporary adhesive layer 1 and the the protective layer 1 from the laminate 4.
(14) A method for producing a semiconductor device, including:
   a step (V) of causing a surface of the laminate obtained by the method for producing a laminate according to the above (12) on the semiconductor layer 1 side to face a surface of a circuit substrate on which a circuit is formed, and bonding the semiconductor layer 1 in the laminate to the circuit substrate by thermocompression-bonding.
(15) The method for producing a semiconductor device according to the above (14), further including:
   after the step (V), a step (VI) of removing a pressure-sensitive adhesive layer-attached support substrate 2 from a structure in which the semiconductor layer 1 in the laminate is bonded to the circuit substrate.
(16) The method for producing a semiconductor device according to the above (14), in which the semiconductor device is a silicon photonic semiconductor device.
(17) A laminate including:
   a support substrate 2, a pressure-sensitive adhesive layer, a semiconductor layer 1, and a protective layer 1 laminated in this order, in which
   the pressure-sensitive adhesive layer has a patterned shape.

### ADVANTAGEOUS EFFECTS OF INVENTION

In the laminate and the method for producing a semiconductor device according to the present invention, a laser lift-off (LLO) technique is used, and thus the semiconductor device can be produced in a shorter period of time than before. In addition, damages to the semiconductor layer can be prevented by protecting the semiconductor layer with a protective layer during the production.

With the laminate according to the present invention, transfer of a semiconductor chip of an epitaxially grown crystal film can be performed by using the laser lift-off (LLO) technique in a wide processing margin, that is, a wide processing condition without damaging the semiconductor chip, which can contribute to mass production. In addition, unlike the related technique, since the epitaxially grown crystal can be transferred without a base substrate, it is not necessary to remove the substrate after the transfer, and an expensive substrate can be reused. In addition, a mounting time per chip is greatly shortened, and the required number of mounting devices is greatly reduced as compared with the case of FC mounting.

### BRIEF DESCRIPTION OF DRAWINGS

[FIG. 1A] FIG. 1A is a schematic cross-sectional view illustrating an example of a laminate 1.
[FIG. 1B] FIG. 1B is a schematic cross-sectional view illustrating an example of the laminate 1.
[FIG. 1C] FIG. 1C is a schematic cross-sectional view illustrating an example of the laminate 1.
[FIG. 2A] FIG. 2A is a schematic cross-sectional view illustrating an example of a laminate 2.
[FIG. 2B] FIG. 2B is a schematic cross-sectional view illustrating an example of the laminate 2.
[FIG. 3A] FIG. 3A is a schematic cross-sectional view illustrating an example of the laminate 1 and a laminate 3, illustrating an example of producing the laminate 3 by laser transfer.
[FIG. 3B] FIG. 3B is a schematic cross-sectional view illustrating an example of the laminate 1 and a laminate 4, illustrating an example of producing the laminate 4 by laser transfer.
[FIG. 4A] FIG. 4A is a schematic cross-sectional view illustrating an example of a state where a protective layer 1 has been removed from the laminate 3 after patterning.
[FIG. 4B] FIG. 4B is a schematic cross-sectional view illustrating an example of a state where the protective layer 1 has been removed from the laminate 3 after patterning.
[FIG. 5] FIG. 5 is a schematic cross-sectional view illustrating an example of transferring a semiconductor layer 1 to a circuit substrate.
[FIG. 6A] FIG. 6A is a schematic cross-sectional view illustrating an example of a process of producing a laminate 0" having a Terher structure.
[FIG. 6B] FIG. 6B is a schematic cross-sectional view illustrating an example of the process of producing the laminate 0" having a Terher structure.
[FIG. 6C] FIG. 6C is a schematic cross-sectional view illustrating an example of the process of producing the laminate 0" having a Terher structure.
[FIG. 6D] FIG. 6D is a schematic cross-sectional view illustrating an example of the process of producing the laminate 0" having a Terher structure.
[FIG. 6E] FIG. 6E is a schematic cross-sectional view illustrating an example of the process of producing the laminate 0" having a Terher structure.
[FIG. 6F] FIG. 6F is a schematic cross-sectional view illustrating an example of a process of producing a laminate 1' from the laminate 0" having a Terher structure.
[FIG. 6G] FIG. 6G is a schematic cross-sectional view illustrating an example of the process of producing the laminate 1' from the laminate 0" having a Terher structure.
[FIG. 7A] FIG. 7A is a schematic cross-sectional view illustrating an example of a process of producing the laminate 1 from a laminate 0 having a Terher structure.
[FIG. 7B] FIG. 7B is a schematic cross-sectional view illustrating an example of the process of producing the laminate 1 from the laminate 0 having a Terher structure.
[FIG. 8A] FIG. 8A is a schematic cross-sectional view illustrating an example of the laminate 4.
[FIG. 8B] FIG. 8B is a schematic cross-sectional view illustrating an example of a state where a laser-absorbing temporary adhesive layer 1 has been removed from the laminate 4.
[FIG. 9A] FIG. 9A is a schematic cross-sectional view illustrating an example of the laminate 3 in which a pressure-sensitive adhesive layer is patterned.
[FIG. 9B] FIG. 9B is a schematic cross-sectional view illustrating an example of the laminate 3 in which the pressure-sensitive adhesive layer is patterned.
[FIG. 10A] FIG. 10A is a schematic cross-sectional view illustrating an example of a process of removing a support substrate 2 in a step (VI).
[FIG. 10B] FIG. 10B is a schematic cross-sectional view illustrating an example of the process of removing the support substrate 2 in the step (VI).
[FIG. 10C] FIG. 10C is a schematic cross-sectional view illustrating an example of the process of removing the support substrate 2 in the step (VI).

### DESCRIPTION OF EMBODIMENTS

Hereinafter, embodiments of the present invention will be described in detail, but the present invention is not limited in any way by these embodiments. "To" in a numerical range includes the numerical values before and after it. For example, "0 to 100" means a range of 0 or more and 100 or less.

A method for producing a laminate according to the present embodiment successively includes:
a step (I) of using a laminate 1, in which a laser-absorbing temporary adhesive layer 1, a protective layer 1, and a semiconductor layer 1 are laminated in this order on a laser-transmitting substrate 1, and a laminate 2, in which a pressure-sensitive adhesive layer is laminated on a support substrate 2, to cause a surface of the laminate 1 on a semiconductor layer 1 side and a surface of the laminate 2 on a pressure-sensitive adhesive layer side to face each other; and
a step (II) of irradiating the laser-absorbing temporary adhesive layer 1 with a laser from a surface side of the laminate 1 opposite to the surface thereof on the semiconductor layer 1 side while transmitting the laser through the laser-transmitting substrate 1, and transferring a structure in which the protective layer 1 and the semiconductor layer 1 are laminated to the laminate 2 to form a laminate 3 in which the pressure-sensitive adhesive layer, the semiconductor layer 1, and the protective layer 1 are laminated in this order on the support substrate 2.

Hereinafter, each component of the laminate according to the present embodiment will be described.

### [Laminate 1]

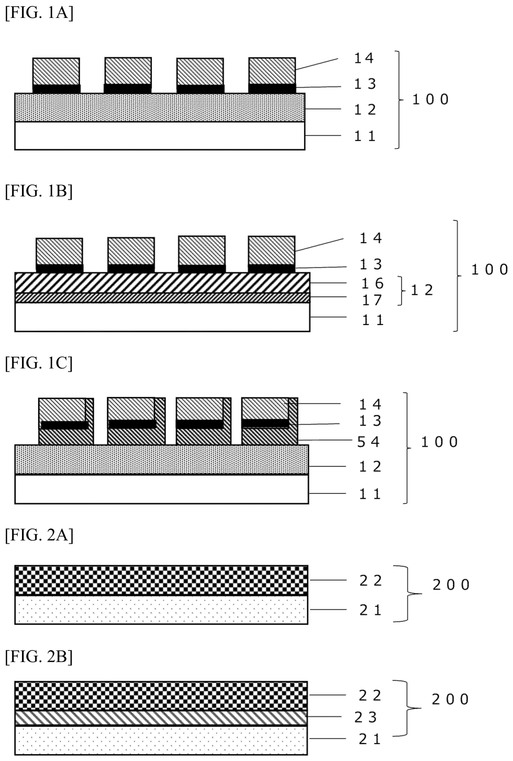

First, for example, as illustrated in FIG. 1A, a laminate 1 (reference numeral 100) in which a laser-absorbing temporary adhesive layer 1 (reference numeral 12), a protective layer 1 (reference numeral 13), and a semiconductor layer 1 (reference numeral 14) are laminated in this order on a laser-transmitting substrate 1 (reference numeral 11) will be described.

### (Laser-Transmitting Substrate 1)

First, the laser-transmitting substrate 1 included in the laminate 1 will be described.

The laser-transmitting substrate 1 is preferably a substrate having an absorbance of 0.1 or less at at least one wavelength of 248 nm, 266 nm, and 355 nm. Examples of the substrate having such an absorbance include an inorganic substrate such as quartz, sapphire, an alkali glass, an alkali-free glass, and a borosilicate glass. In the case of using an inorganic substrate, the thickness of the substrate can be selected within a range that does not impair the absorbance, and is preferably 0.1 mm to 5.0 mm. The thickness of the substrate is more preferably 0.3 mm or more from the viewpoint of a strength of the substrate, and the thickness of the substrate is more preferably 2.0 mm or less from the viewpoint of handling the substrate, for example, a mass or substrate thickness limitation on a device.

As the laser-transmitting substrate 1, an organic substrate such as a PET, an aramid, a polyester, a polypropylene, or a cycloolefin can also be used. In the case of using an organic substrate, the thickness of the substrate can be selected within a range that does not impair the absorbance, and is preferably 0.05 mm to 3.0 mm. The thickness of the substrate is more preferably 0.1 mm or more from the viewpoint of handling the substrate, and the thickness of the substrate is more preferably 1.0 mm or less since light scattering during laser irradiation can be prevented.

### (Laser-Absorbing Temporary Adhesive Layer 1)

Next, the laser-absorbing temporary adhesive layer 1 included in the laminate 1 will be described.

The laser-absorbing temporary adhesive layer 1 is a resin film having laser absorbability, and is a resin film having adhesiveness capable of holding an object on a surface of the resin film. The laser absorbability of the laser-absorbing temporary adhesive layer 1 can be imparted by containing an additive such as an ultraviolet absorber or a dye, a resin having laser absorbability, or the like. The adhesiveness for holding the object in the laser-absorbing temporary adhesive layer 1 can be imparted by containing a resin having adhesiveness, and may be imparted by containing a resin or component having laser absorbability in combination, or a resin or component specialized for the adhesiveness may be added. In addition, the laser-absorbing temporary adhesive layer 1 may contain a component for increasing flexibility and bendability, a crosslinking agent, an additive, a curing accelerator, a silane compound, or the like. The laser-absorbing temporary adhesive layer 1 may be formed by forming a film of a resin composition in a solution state further containing a solvent.

The laser-absorbing temporary adhesive layer 1 preferably has an absorbance of 0.4 or more and 6.0 or less at a thickness of 1.0 µm at at least one wavelength of 248 nm, 266 nm, and 355 nm. In the case where the absorbance is 0.4 or more, in the step (II), when a laser is irradiated from a laser-transmitting substrate 1 side to a laser-absorbing temporary adhesive layer 1 side to transfer a semiconductor element to a facing substrate (this transferring is also referred to as laser lift-off (LLO)), the emitted laser is intensively absorbed by the laser-absorbing temporary adhesive layer 1, and the semiconductor element can be efficiently transferred. The absorbance is more preferably 0.6 or more since the laser can be particularly absorbed in the vicinity of an interface between the laser-absorbing temporary adhesive layer 1 and the laser-transmitting substrate 1, and the transfer can be performed by laser irradiation at a low energy. In addition, the absorbance is preferably 6.0 or less and more preferably 5.0 or less from the viewpoint of material design, and is still more preferably 4.0 or less since a resin having versatility can be used.

The thickness of the laser-absorbing temporary adhesive layer 1 is preferably 1.0 µm to 15 µm and more preferably 3.0 µm to 10 µm, from the viewpoint of transferability in the LLO. In the case where the thickness of the laser-absorbing temporary adhesive layer 1 is 1.0 µm or more, the laser is entirely absorbed by the laser-absorbing temporary adhesive layer 1, and the protective layer 1 and the semiconductor layer 1 can be prevented from being damaged by being directly ablated by the laser. In the case where the thickness of the laser-absorbing temporary adhesive layer 1 is 15 µm or less, a force generated by laser irradiation is sufficiently transmitted to the semiconductor layer 1, and a yield in laser transfer is improved. In the case where the thickness of the laser-absorbing temporary adhesive layer 1 is 3.0 µm or more, the laser-absorbing temporary adhesive layer 1 absorbs an excessive impact due to laser irradiation, and the damages to the semiconductor layer 1 can be prevented. In addition, In the case where the thickness of the laser-absorbing temporary adhesive layer 1 is 10 µm or less, the semiconductor layer 1 can be transferred with high positional accuracy.

The thickness of the laser-absorbing temporary adhesive layer 1 can be measured by cleaving a laminate including this layer and observing a cross section by using a scanning electron microscope.

Examples of the resin contained in the laser-absorbing temporary adhesive layer 1 include, but are not limited to, polyimide-based resins such as a polyimide, a polyimide precursor, a polybenzoxazole, and a polybenzoxazole precursor, an urethane resin, a novolac resin, a polyhydroxystyrene, a polyester resin, an acrylic resin, an aramid resin, a polysiloxane, and a polyimidesiloxane.

From the viewpoint of heat resistance, the laser-absorbing temporary adhesive layer 1 preferably contains the above-described resin in an amount of 10% to 100% on a mass basis.

For the purpose of imparting adhesiveness to the laser-absorbing temporary adhesive layer 1, an acrylic resin, a polysiloxane, or a polyimidesiloxane is preferably contained.

These resins preferably have a conjugated structure in their structure. In the case where the resin has a conjugated structure, the absorbance of the laser-absorbing temporary adhesive layer 1 at a thickness of 1.0 µm at at least one wavelength of 248 nm, 266 nm, and 355 nm can be adjusted to a range of 0.4 or more and 6.0 or less. Examples of the structure having a conjugated structure include an aromatic structure, and among these, it is preferable to have at least one structure of biphenyl, imide, benzoxazole, and benzophenone. The absorbance can be achieved by making 60 mol% or more of monomer residues be the monomer residue having a conjugated structure, with respect to 100 mol% of all monomer residues in the resin contained in the laser-absorbing temporary adhesive layer 1. Only one kind of these resins may be contained, or a plurality of kinds thereof may be contained in the laser-absorbing temporary adhesive layer 1.

From the viewpoint of heat resistance during laser irradiation, the resin contained in the laser-absorbing temporary adhesive layer 1 preferably contains a resin (X) having one or more structures selected from the group consisting of a polyimide having a structure represented by the following formula (1), a polyimide precursor having a structure represented by the following formula (2), a polybenzoxazole having a structure represented by the following formula (3), a polybenzoxazole precursor having a structure represented by the following formula (4), and a copolymer thereof.

From the viewpoint of temporary adhesiveness, the resin (X) is preferably contained in the laser-absorbing temporary adhesive layer 1 in an amount of 10% to 100% on a mass basis. In the present description, "temporary adhesion" refers to a state where an object is temporarily held on a surface of the laser-absorbing temporary adhesive layer 1 due to the adhesiveness of the laser-absorbing temporary adhesive layer 1. At this time, the held object can be finally detached from the surface of the laser-absorbing temporary adhesive layer 1 by using a peeling method represented by laser irradiation to be described later.

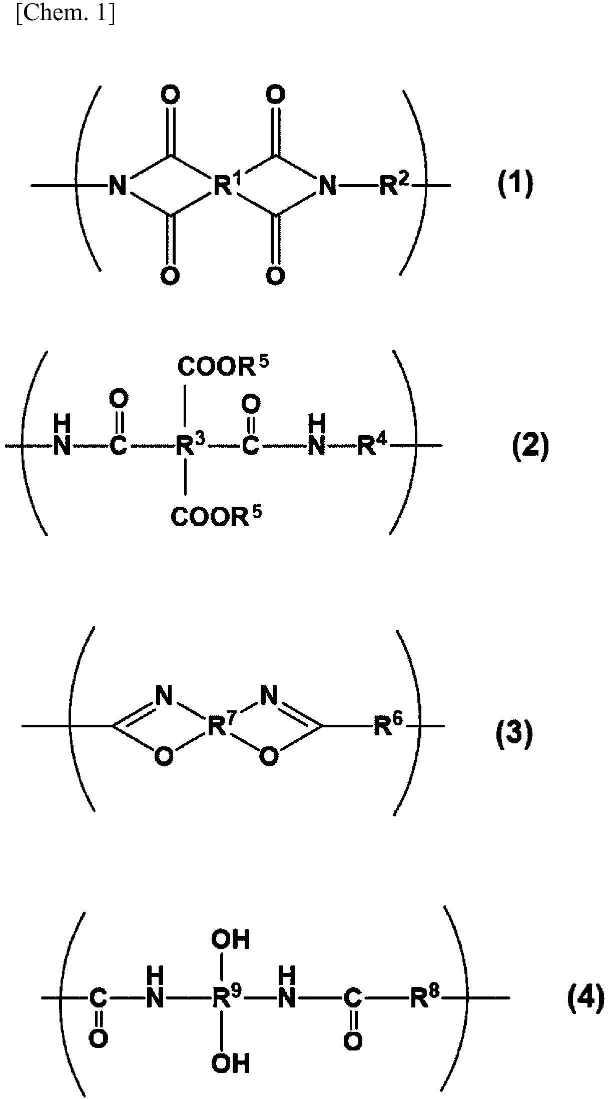

In the formula (1) to the formula (4), R¹, R³, R⁷, and R⁹ each independently represent a tetravalent organic group having 6 to 40 carbon atoms, and R², R⁴, R⁶, and R⁸ each independently represent a divalent organic group having 2 to 40 carbon atoms. R⁵ represents a hydrogen atom or a monovalent organic group having 1 to 20 carbon atoms.

The polyimide and the polybenzoxazole are resins having a cyclic structure of an imide ring or an oxazole ring, respectively, in the main chain structure. The polyimide precursor and the polybenzoxazole precursor, which are precursors thereof, are resins that can form an imide ring or a benzoxazole ring structure, respectively, by dehydration ring closure. It is preferable that 10 to 100,000 structures represented by one or more selected from the group consisting of the above described formula (1) to formula (4) are contained as a repeating unit in one molecule of the resin (X). Within this range, the laser-absorbing temporary adhesive layer 1 can be applied at an appropriate thickness.

The polyimide can be obtained by reacting a tetracarboxylic acid or a corresponding tetracarboxylic acid dianhydride, a tetracarboxylic acid diester dichloride, or the like with a diamine or a corresponding diisocyanate compound, a trimethylsilylated diamine, or the like, and preferably has a tetracarboxylic acid residue and a diamine residue. For example, the polyimide can be obtained by subjecting a polyamide acid, which is one of polyimide precursors obtained by reacting a tetracarboxylic acid dianhydride with a diamine, to dehydration ring closure by a heat treatment. During the heat treatment, a solvent that forms an azeotrope with water, such as m-xylene, can be added. Alternatively, the polyimide can also be obtained by adding a dehydration condensation agent such as a carboxylic acid anhydride or dicyclohexylcarbodiimide, or a ring-closing catalyst such as a base (e.g., triethylamine), and performing dehydration ring closure by a chemical heat treatment. Alternatively, the polyimide can also be obtained by adding a weakly acidic carboxylic acid compound and performing dehydration ring closure by a heat treatment at a low temperature of 100°C or lower.

The polybenzoxazole can be obtained by reacting a bisaminophenol compound with a dicarboxylic acid or a corresponding dicarboxylic acid chloride, a dicarboxylic acid active ester, or the like, and preferably has a dicarboxylic acid residue and a bisaminophenol residue. For example, the polybenzoxazole can be obtained by subjecting polyhydroxyamide, which is one of polybenzoxazole precursors obtained by reacting a bisaminophenol compound with a dicarboxylic acid, to dehydration ring closure by a heat treatment. Alternatively, the polybenzoxazole can be obtained by adding phosphoric acid anhydride, a base, a carbodiimide compound, or the like, and performing dehydration ring closure by a chemical treatment.

In the formula (1) and the formula (2), R¹ and R³(COOR⁵)₂ preferably represent a tetracarboxylic acid residue. Examples of the tetracarboxylic acid residue constituting R¹ or R³(COOR⁵)₂ include aromatic tetracarboxylic acid residues such as pyromellitic acid, 3,3',4,4'-biphenyltetracarboxylic acid, 3,3',4,4'-benzophenonetetracarboxylic acid, 2,2-bis(3,4-dicarboxyphenyl)hexafluoropropane, bis(3,4-dicarboxyphenyl)sulfone, and bis(3,4-dicarboxyphenyl)ether, and aliphatic tetracarboxylic acid residues such as 1,2,3,4-cyclopentanetetracarboxylic acid. Two or more kinds of these tetracarboxylic acid residues may be contained. The tetracarboxylic acid residue preferably has an aromatic group from the viewpoint of absorbance.

In the formula (1) and the formula (2), R² and R⁴ each preferably represent a diamine derivative residue. Examples of the diamine derivative residue constituting R² and R⁴ include: hydroxy group-containing diamine residues such as 2,2-bis(3-amino-4-hydroxyphenyl)hexafluoropropane, bis(3-amino-4-hydroxyphenyl)sulfone, and 2,2-bis(3-amino-4-hydroxyphenyl)propane; sulfonic acid group-containing diamine residues such as 3-sulfonic acid-4,4'-diaminodiphenyl ether; thiol group-containing diamine residues such as dimercaptophenylenediamine; aromatic diamine residues such as 3,4'-diaminodiphenyl ether, 3,4'-diaminodiphenyl sulfone, p-phenylenediamine, and 2,2'-bis(trifluoromethyl)-4,4'-diaminobiphenyl; compounds in which one or some of hydrogen atoms in these aromatic rings have been substituted with an alkyl group or a fluoroalkyl group having 1 to 10 carbon atoms, or a halogen atom; and alicyclic diamine residues such as cyclohexyldiamine and methylenebiscyclohexylamine. Two or more kinds of these diamine residues may be contained in combination. From the viewpoint of absorbance, in the laser-absorbing temporary adhesive layer 1, the aromatic diamine residue is preferably 30 mol% or more of all diamine residues.

In the formula (2), R⁵ represents a hydrogen atom or a monovalent organic group having 1 to 20 carbon atoms. Examples of the organic group having 1 to 20 carbon atoms include a methyl group, an ethyl group, a propyl group, an isopropyl group, a butyl group, a pentyl group, a hexyl group, a cyclohexyl group, an octyl group, a dodecyl group, and a phenyl group. A methyl group or an ethyl group is preferred from the viewpoint of availability of a raw material for polymerization.

In the formula (3) and the formula (4), R⁶ and R⁸ each preferably represent a dicarboxylic acid residue, a tricarboxylic acid residue, or a tetracarboxylic acid residue.

Examples of the dicarboxylic acid residue include residues of terephthalic acid, isophthalic acid, diphenyl ether dicarboxylic acid, bis(carboxyphenyl)hexafluoropropane, biphenyl dicarboxylic acid, benzophenone dicarboxylic acid, and triphenyl dicarboxylic acid. Examples of the tricarboxylic acid residue include residues of trimellitic acid, trimesic acid, diphenyl ether tricarboxylic acid, and biphenyl tricarboxylic acid. Examples of the tetracarboxylic acid residue are the same as the examples of the tetracarboxylic acid residue exemplified as the examples for R¹ and R³(COOR⁵)₂. Two or more kinds of these may be contained.

In the formula (3) and the formula (4), R⁷ and R⁹(OH)₂ each preferably represent a bisaminophenol derivative residue. Specific examples of the bisaminophenol derivative residue include, but are not limited to, residues of bis(3-amino-4-hydroxyphenyl)propane, bis(3-amino-4-hydroxyphenyl)sulfone, 2,2-bis(3-amino-4-hydroxyphenyl)-1,1,1,3,3,3-hexafluoropropane, and 2,2-bis(4-amino-3-hydroxyphenyl)-1,1,1,3,3,3-hexafluoropropane. These compounds may be contained alone or in combination of two or more kinds thereof.

In addition, a resin having an acidic group at the terminal of the main chain can be obtained by sealing the terminal of the resins represented by the formula (1) to the formula (4) with a monoamine, an acid anhydride, an acid chloride, or a monocarboxylic acid, having an acidic group.

Preferred examples of such a monoamine include 2-aminophenol, 3-aminophenol, and 4-aminophenol. Two or more kinds of these may be contained.

Preferred examples of such an acid anhydride, an acid chloride, and a monocarboxylic acid include known compounds such as phthalic acid anhydride, maleic acid anhydride, and nadic acid anhydride. Di-tert-butyl dicarbonate or the like is also preferably used as the reactive terminal. Two or more kinds of these may be contained.

The resin (X) preferably has any one or more structures selected from the group consisting of a dimethylsiloxane structure represented by a formula (5), a diphenylsiloxane structure represented by a formula (6), an alkylene glycol structure represented by a formula (7), and an alkylene structure represented by a formula (8). By having such a structure having flexibility, development of the temporary adhesiveness can be expected.

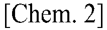

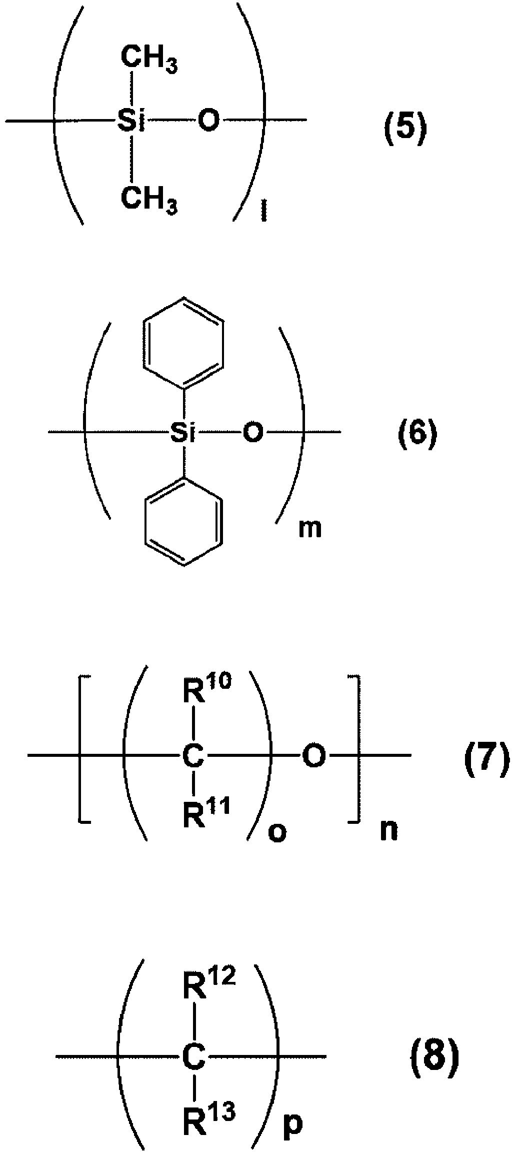

In the formula (5) to the formula (8), R¹⁰ to R¹³ each independently represent a hydrogen atom or a monovalent organic group having 1 to 20 carbon atoms. 1, m, and n each independently represent an integer of 4 to 40. p represents an integer of 10 to 40. o represents an integer of 1 to 16.

In the case where the resin (X) has any one or more structures selected from the group consisting of the structures represented by the formula (5) to the formula (8) in the structure, there is an effect of improving flexibility and adhesive strength of the laser-absorbing temporary adhesive layer 1. R¹⁰ to R¹³ are the same as described for R⁵.

Specific examples of the any one or more structures selected from the group consisting of the structures represented by the formula (5), the formula (6), the formula (7), and the formula (8) include: as an aliphatic diamine residue, a diamine residue containing a polyethylene oxide group such as JEFFAMINE (registered trademark) KH-511, JEFFAMINE (registered trademark) ED-600, JEFFAMINE (registered trademark) ED-900, and polyoxypropylene diamine D-400 and D-2000 (manufactured by Huntsman International LLC.); a diamine residue having a polyalkylene oxide group such as ELASMER (registered trademark) 250P, ELASMER (registered trademark) 1000P, and Porea (registered trademark) SL100A (manufactured by KUMIAI CHEMICAL INDUSTRY CO., LTD.); and a siloxanediamine residue such as LP-7100, KF-8010, KF-8012, and X22-161A (manufactured by Shin-Etsu Chemical Co., Ltd.), which is a siloxanediamine at a propylamine terminal. Two or more kinds of these diamine residues may be used in combination.

Further, the resin (X) is more preferably a polyimidesiloxane. The polyimidesiloxane is a resin having a siloxane structure in a polyimide repeating structure, and the polyimidesiloxane as the resin (X) particularly preferably has a siloxanediamine residue represented by the formula (9) in the structure.

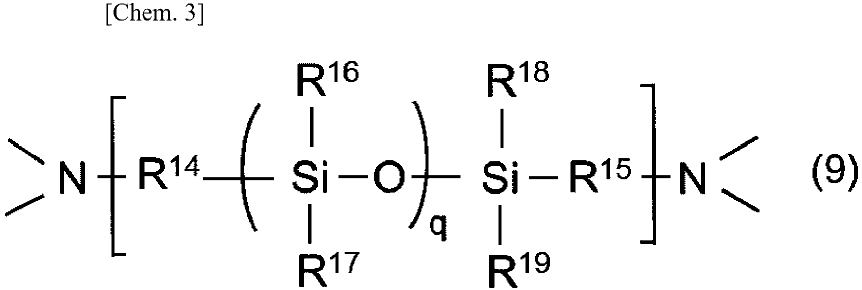

In the formula (9), q is a natural number of 1 to 50. R¹⁴ and R¹⁵ may be the same as or different from each other, and each represent an alkylene group having 1 to 30 carbon atoms or a phenylene group. R¹⁶ to R¹⁹ may be the same as or different from each other, and each represent an alkyl group having 1 to 30 carbon atoms, a phenyl group, or a phenoxy group.

Examples of the siloxanediamine residue represented by the formula (9) include those derived from the following diamines. Specific examples thereof include residues of α,ω-bis(3-aminopropyl)polydimethylsiloxane, α,ω-bis(3-aminopropyl)polydiphenoxysiloxane, α,ω-bis(4-aminophenyl)polydimethylsiloxane, and α,ω-bis(4-aminophenyl)polydiphenoxysiloxane. Only one kind of the siloxanediamine residue may be contained, or two or more kinds thereof may be contained. The polyimidesiloxane is characterized by high adhesive strength and a high absorbance derived from the polyimide, and can particularly increase the absorbance at 355 nm or the like.

In the laminate 1 according to the present embodiment, it is preferable that the 1% mass loss temperature of at least one resin among the resins to be contained in the laser-absorbing temporary adhesive layer 1 is 300°C or higher, and it is more preferable that the 1% mass loss temperature of all the resins to be contained in the laser-absorbing temporary adhesive layer 1 is 300°C or higher. In the present description, the "1% mass loss temperature" is defined as follows. After the resin is subjected to a heat treatment at 250°C for 30 minutes, when, by using thermogravimetric analysis (TGA), the resin is held at 100°C for 5 minutes under nitrogen and then heated at a rate of 10°C/min, and the mass at 100°C is defined as 100%, a temperature at which the mass is reduced by 1% is defined as the "1% mass loss temperature". Even for a resin that has already been heat-treated, the 1% mass loss temperature can also be checked by further heat-treating the resin at 250°C for 30 minutes. In the case where the 1% mass loss temperature is 300°C or higher, deterioration of the entire laser-absorbing temporary adhesive layer 1 due to heat generated during laser irradiation can be prevented. Accordingly, it is possible to prevent a deteriorated laser-absorbing temporary adhesive layer 1 from scattering and contaminating a device or the like. Fragments caused by such scattering of the laser-absorbing temporary adhesive layer 1 are hereinafter referred to as "debris".

In order to control the 1% mass loss temperature to 300°C or higher, the resin preferably contains a component having high thermal stability. Specific examples of the component having high thermal stability include a rigid component such as an aromatic ring, a siloxane having relatively high thermal stability among flexible structures, and a combination thereof. In the case where 50% or more of monomer residues are the monomer residue having high thermal stability with respect to 100 mol% of all monomer residues constituting the resin contained in the laser-absorbing temporary adhesive layer 1, the 1% mass loss temperature can be 300°C or higher. From the viewpoint of versatility of the resin, the 1% mass loss temperature is preferably 600°C or lower.

In addition, it is also possible to achieve the above absorbance by containing an additive such as an ultraviolet absorber or a dye in the laser-absorbing temporary adhesive layer 1. Examples of the additive to be contained in the laser-absorbing temporary adhesive layer 1 include an ultraviolet absorber such as Tinuvin (registered trademark) PS or the like (manufactured by BASF Japan Ltd.) and DAINSORB (registered trademark) T-0 and DAINSORB (registered trademark) T-7 or the like (manufactured by Daiwa Fine Chemicals Co., Ltd.), and a dye such as Solvent Yellow 93 or the like (manufactured by Tokyo Chemical Industry Co., Ltd.).

Only one kind of these additives may be contained, or a plurality of kinds thereof may be contained in the laser-absorbing temporary adhesive layer 1. The content of the additive for controlling the absorbance to the above range is, with respect to 100 parts by mass of the entire laser-absorbing temporary adhesive layer 1, preferably 0.1 parts by mass or more and is preferably 70 parts by mass or less from the viewpoint of stability in a varnish state before forming the laminate.

The laser-absorbing temporary adhesive layer 1 preferably has an adhesive strength of 0.02 N/cm or more and 0.3 N/cm or less at an interface with an adjacent photoresist or protective layer 1 to be described later. Here, the adhesive strength refers to a value obtained from a 90° peel test on a polyimide film and an exposed surface of the laser-absorbing temporary adhesive layer 1 after removing a structure in which the photoresist, the protective layer 1, and the semiconductor layer 1 are laminated from the laminate 1. In the case where the laminate 1 does not include a photoresist, the adhesive strength refers to a value obtained from the 90° peel test after removing a structure in which the protective layer 1 and the semiconductor layer 1 are laminated from the laminate 1.

As a specific measurement method, Kapton (registered trademark) 100EN (manufactured by DU PONT-TORAY CO., LTD.), which is a polyimide film, cut into 1 cm × 9 cm, is pressure-bonded to the laser-absorbing temporary adhesive layer 1 by using a vacuum laminator under conditions of 0.1 MPa and 25°C, and the pressure-bonded polyimide film is subjected to a peel test by a tensile tester at a constant speed of 2 mm/sec in a direction perpendicular to the laser-absorbing temporary adhesive layer 1.

In the case where the adhesive strength is 0.02 N/cm or more, the structure in which the protective layer 1 and the semiconductor layer 1 are laminated can be stably held on the laser-absorbing temporary adhesive layer 1. In addition, in the case where the adhesive strength is 0.3 N/cm or less, the structure in which the protective layer 1 and the semiconductor layer 1 are laminated can be transferred to a laminate 2 to be described later by laser irradiation at a low energy. The adhesive strength is more preferably 0.2 N/cm or less, and at this time, the laser irradiation energy during the transfer can be further reduced, and a risk of damages to the semiconductor element can be reduced.

In order to control the adhesive strength of the laser-absorbing temporary adhesive layer 1 within the above range, the laser-absorbing temporary adhesive layer 1 preferably contains a component for improving flexibility and bendability. By introducing a component for improving flexibility and bendability, a glass transition temperature can be lowered and the adhesive strength can be increased. Examples of the component for improving flexibility and bendability include: a flexible structure derived from an aliphatic or silane such as an alkylene group or siloxane; a flexible structure derived from an ether group such as an alkylene glycol or biphenyl ether; and a bendable structure such as an alicyclic structure or olefins. The adhesive strength can be controlled to 0.02 N/cm or more by containing 20 mol% or more of the monomer residue having a structure imparting flexibility, and the adhesive strength can be controlled to 0.3 N/cm or less by containing 70 mol% or less of the monomer residue, with respect to 100 mol% of all the monomer residues constituting the resin contained in the laser-absorbing temporary adhesive layer 1.

On the other hand, for the laser-absorbing temporary adhesive layer 1 having an adhesive strength of more than 0.3 N/cm, when a part of the structure is crosslinked by adding a crosslinking agent to harden the surface of the laser-absorbing temporary adhesive layer 1, the adhesive strength can be reduced to the above range. Further, since the surface of the laser-absorbing temporary adhesive layer 1 is crosslinked and strengthened, cohesive failure of the laser-absorbing temporary adhesive layer 1 can be prevented. Accordingly, when the laser-absorbing temporary adhesive layer 1 is peeled off from the surface of the photoresist or the protective layer 1, it is possible to prevent a residue of the laser-absorbing temporary adhesive layer 1 from adhering to the surface of the photoresist or the protective layer 1. In this way, in the case where a residue of the adhesive layer or pressure-sensitive adhesive layer to be described later remains on the surface of an adhesion target substance, the residue is hereinafter referred to as an "adhesive residue".

Examples of the crosslinking agent that may be contained in the laser-absorbing temporary adhesive layer 1 include a compound having an alkoxymethyl group or a methylol group, and examples thereof include NIKALAC (registered trademark) and MW-100LM (manufactured by SANWA CHEMICAL CO., LTD.).

In addition, the crosslinking agent is also preferably a compound having an epoxy group, and examples thereof include epoxy group-containing silicones such as a bisphenol A type epoxy resin, a bisphenol F type epoxy resin, propylene glycol diglycidyl ether, polypropylene glycol diglycidyl ether, and polymethyl(glycidyloxypropyl)siloxane, and a dimer acid-modified epoxy resin, but the crosslinking agent used in the present embodiment is not limited thereto. Specific examples thereof include JER (registered trademark) 871 (manufactured by Mitsubishi Chemical Group Corporation) and Shofree (registered trademark) PETG (Resonac Holdings Corporation.).

Only one kind of the crosslinking agent may be contained, or two or more kinds thereof may be contained in the laser-absorbing temporary adhesive layer 1. The crosslinking agent is preferably contained in an amount of 1 to 30 parts by mass in 100 parts by mass of the laser-absorbing temporary adhesive layer 1.

In the case where the crosslinking agent is preferably contained in an amount of 1 part by mass or more in 100 parts by mass of the laser-absorbing temporary adhesive layer 1, the amount of the adhesive residue can be reduced. In the case where the crosslinking agent is more preferably contained in an amount of 5 parts by mass or more in 100 parts by mass of the laser-absorbing temporary adhesive layer 1, the effect of preventing adhesive residue can be highly obtained. In addition, the crosslinking agent is preferably contained in an amount of 30 parts by mass or less in 100 parts by mass of the laser-absorbing temporary adhesive layer 1. Within this range, certain flexibility is maintained in the laser-absorbing temporary adhesive layer 1. In addition, the crosslinking agent is more preferably contained in an amount of 20 parts by mass or less in 100 parts by mass of the laser-absorbing temporary adhesive layer 1, from the viewpoint of storage stability in the varnish state before forming the laminate.

In the case where the laser-absorbing temporary adhesive layer 1 contains a crosslinking agent, the laser-absorbing temporary adhesive layer 1 may contain a curing accelerator for the purpose of accelerating curing by the crosslinking agent. Examples of the curing accelerator include imidazoles, tertiary amines or salts thereof, and organic boron salt compounds, and among these, imidazoles are preferred. Specific examples of the imidazoles include imidazole, 1,2-dimethylimidazole, 2-ethyl-4-methylimidazole, 2-phenyl-1H-imidazole, 2,4-diamino-6-[2'-ethyl-4-methylimidazolyl-(1')]-ethyl-s-triazine, and a 2-methylimidazole isocyanuric acid adduct. In addition, examples of preferred commercially available imidazoles include CUREZOL (registered trademark) 2E4MZ and CUREZOL (registered trademark) 2E4MZ-CN (manufactured by SHIKOKU CHEMICALS CORPORATION).

The content of the curing accelerator is preferably 0.1 parts by mass or more and 5.0 parts by mass or less with respect to 100 parts by mass of the crosslinking agent. Within this range, a sufficient crosslinking promoting effect can be obtained. The content of the curing accelerator is more preferably 0.5 parts by mass or more and 2.0 parts by mass or less with respect to 100 parts by mass of the crosslinking agent, from the viewpoint of maintaining stability in the varnish state before forming the laminate 1.

In addition, the laser-absorbing temporary adhesive layer 1 may further contain a silane compound as necessary. By containing the silane compound, the adhesion between the laser-absorbing temporary adhesive layer 1 and the laser-transmitting substrate 1 can be adjusted. Accordingly, it is possible to prevent the laser-absorbing temporary adhesive layer 1 in a laser-unirradiated portion from peeling off from the laser-transmitting substrate 1. Specific examples of the silane compound include N-phenylaminoethyltriethoxysilane, vinyltriethoxysilane, 3-methacryloxypropyltrimethoxysilane, and p-styryltrimethoxysilane. The content of the silane compound is preferably 0.01 parts by mass or more and 15 parts by mass or less with respect to 100 parts by mass of the laser-absorbing temporary adhesive layer 1.

Further, the laser-absorbing temporary adhesive layer 1 may contain a surfactant as necessary for the purpose of improving wettability with the laser-transmitting substrate 1 during film formation and forming the laser-absorbing temporary adhesive layer 1 with a uniform thickness.

### ((Laser-Absorbing Layer 1 and Temporary Adhesive Layer 2))

In addition, the laser-absorbing temporary adhesive layer 1 preferably has a structure of two or more layers including a laser-absorbing layer 1 and a temporary adhesive layer 2 since the effect of preventing the damages to the semiconductor layer 1 to be described later is further improved. At this time, the laser-absorbing layer 1 preferably does not have adhesiveness. At this time, for example, as illustrated in FIG. 1B, the laminate 1 (reference numeral 100) is formed by laminating at least the laser-absorbing temporary adhesive layer 1 (reference numeral 12) including the laser-absorbing layer 1 (reference numeral 17) and the temporary adhesive layer 2 (reference numeral 16), the protective layer 1 (reference numeral 13), and the semiconductor layer 1 (reference numeral 14) in this order on the laser-transmitting substrate 1 (reference numeral 11).

The thickness of the laser-absorbing layer 1 is preferably 0.1 µm to 5 µm, preferably 0.1 µm or more and more preferably 0.3 µm or more, and is preferably 5 µm or less and more preferably 3 µm or less.

The thickness of the temporary adhesive layer 2 is preferably 0.1 µm to 10 µm, preferably 0.1 µm or more and more preferably 0.3 µm or more, and is preferably 10 µm or less and more preferably 5 µm or less. In the case where the thickness of the temporary adhesive layer 2 is 0.1 µm or more, the protective layer 1 can be stably adhered, and in the case where the thickness is 10 µm or less, the energy during laser transfer of the semiconductor element can be reduced. The total thickness of the laser-absorbing layer 1 and the temporary adhesive layer 2 is preferably 1.0 µm or more and 15 µm or less.

The thicknesses of the laser-absorbing layer 1 and the temporary adhesive layer 2 can be measured by cleaving a laminate including these layers and observing the cross section by using a scanning electron microscope.

The laser-absorbing layer 1 is an inorganic film or an organic film. The laser-absorbing layer 1 preferably has an absorbance of 0.4 or more and 6.0 or less at a thickness of 1.0 µm at at least one wavelength of 248 nm, 266 nm, and 355 nm. In the case where the absorbance is 0.4 or more, in the step (II), when a laser is irradiated from the laser-transmitting substrate 1 side to a laser-absorbing layer 1 side to transfer the semiconductor layer 1 to a facing substrate, the emitted laser is intensively absorbed by the laser-absorbing layer 1, and the semiconductor layer 1 can be efficiently transferred. The absorbance is more preferably 0.6 or more since the laser can be absorbed by the laser-absorbing layer 1 particularly in the vicinity of the outermost surface, and the transfer can be performed by laser irradiation at a low energy. In addition, the absorbance is preferably 6.0 or less from the viewpoint of material design, and is more preferably 5.0 or less since an inorganic film or organic film having versatility can be used.

As the organic film contained in the laser-absorbing layer 1, a polyimide, a polyimide precursor, a polybenzoxazole, a polybenzoxazole precursor, a urethane resin, a novolac resin, a polyhydroxystyrene, a polyester resin, an acrylic resin, an aramid resin, or the like can be suitably used. These may also be contained in the temporary adhesive layer 2.

As the inorganic film contained in the laser-absorbing layer 1, for example, one or more inorganic substances selected from the group consisting of a metal, a metal compound, and carbon can be suitably used.

The metal is preferably at least one selected from gold, silver, copper, iron, nickel, aluminum, titanium, chromium, and an alloy thereof. The alloy is preferably silver-tin.

The metal compound refers to a compound containing a metal atom, and may be, for example, a metal oxide or a metal nitride.

Note that, carbon is a concept that may include allotropes of carbon, and may be, for example, diamond, fullerene, diamond-like carbon, carbon nanotube, or the like.

Examples of such an inorganic substance include, but are not limited to, one or more inorganic substances selected from the group consisting of a metal such as gold, platinum, palladium, cobalt, rhodium, iridium, calcium, ruthenium, osmium, manganese, molybdenum, tungsten, niobium, tantalum, bismuth, antimony, lead, silver, copper, iron, nickel, aluminum, titanium, chromium, tin, and an alloy thereof, a metal compound such as SiO₂, SiN, Si₃N₄, and TiN, and carbon.

In the case where the organic film has a conjugated structure, the absorbance of the laser-absorbing layer 1 at a thickness of 1.0 µm at at least one wavelength of 248 nm, 266 nm, and 355 nm can be adjusted to a range of 0.4 or more and 6.0 or less. Examples of the structure having a conjugated structure include an aromatic structure, and among these, it is preferable to have at least one structure of biphenyl, imide, benzoxazole, and benzophenone. The absorbance can be adjusted to the above range by making 60 mol% or more of monomer residues be the monomer residue having a conjugated structure, with respect to 100 mol% of all monomer residues in the resin contained in the laser-absorbing layer 1. Only one kind of these resins may be contained, or a plurality of kinds thereof may be contained in the laser-absorbing layer 1.

In addition, it is also possible to achieve the above absorbance by containing an additive such as an ultraviolet absorber or a dye. Examples of the additive to be contained in the laser-absorbing layer 1 include an ultraviolet absorber such as Tinuvin (registered trademark) 477, Tinuvin (registered trademark) 479 (manufactured by BASF Japan Ltd.), Tinuvin (registered trademark) 400, and DAINSORB (registered trademark, manufactured by Daiwa Fine Chemicals Co., Ltd.), and a dye such as Violet 36 (manufactured by Tokyo Chemical Industry Co., Ltd.).

Only one kind of these additives may be contained, or a plurality of kinds thereof may be contained in the laser-absorbing layer 1. The content of the additive for controlling the absorbance to the above range, with respect to 100 parts by mass of the entire laser-absorbing layer 1, is preferably 0.1 parts by mass or more, and is preferably 50 parts by mass or less from the viewpoint of stability in the varnish state before forming the laminate.

In addition, the laser-absorbing layer 1 may further contain a silane compound as necessary. By containing the silane compound, the adhesion between the laser-absorbing layer 1 and the laser-transmitting substrate 1 can be adjusted. Accordingly, it is possible to prevent the laser-absorbing layer 1 in a laser-unirradiated portion from peeling off from the laser-transmitting substrate 1. Specific examples of the silane compound include silane compounds that are exemplified as capable of being contained in the laser-absorbing temporary adhesive layer 1, and the preferred content is also the same.

In addition, the laser-absorbing layer 1 may contain a surfactant as necessary for the purpose of improving wettability with the laser-transmitting substrate 1 during film formation and forming the laser-absorbing layer 1 with a uniform thickness. It is preferable that the laser-absorbing layer 1 does not have a pressure-sensitive adhesive property, and it is preferable that the laser-absorbing layer 1 can be easily removed from the support substrate 2 when the laser-absorbing layer 1 moves to the support substrate 2 side together with the semiconductor layer 1 and the like after the LLO in the step (II).

The temporary adhesive layer 2 may be a layer having the same composition and physical properties as those of the laser-absorbing temporary adhesive layer 1 defined above, a layer having no laser absorption performance, or a layer having the same composition and physical properties as those of the pressure-sensitive adhesive layer to be described later. In the case where the temporary adhesive layer 2 contains the resin (X), the resin (X) preferably has the structure represented by the formula (9). The temporary adhesive layer 2 is preferably a layer having the same composition and physical properties as those of the pressure-sensitive adhesive layer to be described later, from the viewpoint of, in a step (III) of patterning the pressure-sensitive adhesive layer, removing the temporary adhesive layer 2 simultaneously with the pressure-sensitive adhesive layer when partially removing the pressure-sensitive adhesive layer.

### (Semiconductor Layer 1)

Next, the semiconductor layer 1 included in the laminate 1 will be described.

The semiconductor layer 1 preferably includes an epitaxially grown crystal film. The epitaxially grown crystal film is preferably made of a compound semiconductor, particularly a Group III-V compound semiconductor. The epitaxially grown crystal film is preferably made of a compound semiconductor such as AlGaInAs, InGaAs, InP, InGaAsP, AlAs, InAs, GaAs, AlN, AlP, GaN, InN, SiC, and AlGaS. The semiconductor element using these epitaxially grown crystal films may contain only one kind of compound semiconductor, may contain two or more kinds of compound semiconductors, may be a semiconductor element in which different kinds of semiconductors are laminated, or may be a semiconductor element in which a semiconductor substrate, an electrode material, a sapphire substrate or a glass substrate, a wiring, and the like are laminated. The size of the semiconductor layer 1 on a maximum side is preferably 5 µm or more and 5.0 mm or less, and more preferably 1.0 mm or less. The thickness of the epitaxially grown crystal film is preferably 0.005 µm or more and 10 µm or less. In the case where the thickness of the epitaxially grown crystal film is less than 0.005 µm, there is a risk of damages during transfer, and in the case where it is more than 10 µm, it takes a huge amount of time to form the epitaxially grown crystal film, which is not realistic. The size of the epitaxially grown crystal film can be adjusted by using, for example, the method described in Non Patent Literature 2 (Jing Zhang et al., III-V-on-Si photonic integrated circuits realized using micro-transfer-printing, APL Photon., 2019, 4, 110803).

### (Photoresist)

Next, a photoresist that may be included in the laminate 1 will be described. The laminate 1 preferably includes a photoresist between the laser-absorbing temporary adhesive layer 1 and the protective layer 1. In this case, for example, as illustrated in FIG. 1C, the laminate 1 (reference numeral 100) is formed by laminating the laser-absorbing temporary adhesive layer 1 (reference numeral 12), a photoresist layer (reference numeral 54), the protective layer 1 (reference numeral 13), and the semiconductor layer 1 (reference numeral 14) on the laser-transmitting substrate 1 (reference numeral 11).

The photoresist is a substance having photosensitivity and capable of forming an image layer on the surface by patterning through imagewise exposure and development, and contains a photosensitizer and a resin. A positive type or a negative type is applicable. Non Patent Literature 2 (Jing Zhang et al., III-V-on-Si photonic integrated circuits realized using micro-transfer-printing, APL Photon., 2019, 4, 110803) discloses that a photoresist is used as "Tether" for holding a wafer and an epitaxially grown crystal film in a hollow. In the present embodiment, the photoresist is applied as the Tether, too. This photoresist can also be used as the protective layer 1 itself.

### (Protective Layer 1)

Next, the protective layer 1 included in the laminate 1 will be described.

The protective layer 1 is a layer formed adjacent to the semiconductor layer 1 in order to protect the semiconductor layer 1. The semiconductor layer 1 that may include an epitaxially grown crystal film is formed on a semiconductor wafer, and then the protective layer 1 is formed. The protective layer 1 may be an organic film or an inorganic film. Examples of the organic film include the photoresist described above and a soluble polyimide-based resin, and a photoresist is preferred for easily forming the laminate 1, and is also preferred since it can be used as the Tether described above. The inorganic film may be a film formed by vapor phase growth or a film formed by a coating method. As the inorganic film, silicon, titanium, tungsten, an oxide, and a nitride are preferred from the viewpoint of heat resistance. The protective layer 1 is preferably at least one of an oxide film and a nitride film from the viewpoint of ease of film formation, more preferably a layer containing at least one of a silicon oxide and a silicon nitride from the viewpoint of workability when partially removing the pressure-sensitive adhesive layer to be described later, and particularly preferably contains silicon dioxide (SiO₂).

From the viewpoint of protecting the semiconductor layer 1, the thickness of the protective layer 1 is preferably 0.1 µm or more and less than 5 µm, preferably 0.1 µm or more, and more preferably 0.3 µm or more. In the case where the thickness of the protective layer 1 is 0.1 µm or more, an effect of preventing the damages to the semiconductor layer 1 when a layer including the semiconductor layer 1 is laminated on the laser-absorbing temporary adhesive layer 1 is easily obtained. Further, in the case where the thickness of the protective layer 1 is 0.3 µm or more, the effect of preventing the damages to the semiconductor layer 1 is improved when subjecting the semiconductor layer 1 to laser transfer from the laminate 1 to the laminate 2. The thickness of the protective layer 1 is preferably less than 5 µm, and particularly in the case where the protective layer 1 is an inorganic film, the time required for film formation can be shortened. In the case where the protective layer 1 is prepared as an inorganic film, it can be prepared by a known method such as a CVD technique.

### [Features of Laminate 1]

The number of small pieces of the semiconductor layer 1 to be mounted on the laminate 1 according to the present embodiment is preferably 5 pieces/cm² to 50,000 pieces/cm², preferably 5 pieces/cm² or more, and still more preferably 10 pieces/cm² or more. By setting the number of the semiconductor layer 1 to 5 pieces/cm² or more, the effect of improving a throughput by using laser transfer is improved. In addition, since each small piece of the semiconductor layer 1 can be accurately irradiated with laser, the number of small pieces of the semiconductor layer 1 to be mounted on the laminate 1 according to the present embodiment is preferably 50,000 pieces/cm² or less, and still more preferably 10,000 pieces/cm² or less.

As long as the laser-absorbing temporary adhesive layer 1, the protective layer 1, and the semiconductor layer 1 are laminated in this order on the laser-transmitting substrate 1, the laminate 1 according to the present embodiment may have another layer therebetween. The laminate 1 preferably includes the photoresist described above between the laser-absorbing temporary adhesive layer 1 and the protective layer 1. However, the protective layer 1 is formed adjacent to the semiconductor layer 1, and the laser-transmitting substrate 1 and the semiconductor layer 1 are located on the outermost surface of the laminate 1.

### [Method for Producing Laminate 1]

Next, a method for producing the laminate 1 will be described in detail.

The laminate 1 can be formed by forming the laser-absorbing temporary adhesive layer 1 on the laser-transmitting substrate 1 and pressure-bonding the laser-absorbing temporary adhesive layer 1 and the protective layer 1-attached semiconductor layer 1 described above.

An example of the method for producing the laminate 1 will be described.

A varnish obtained by dissolving material components of the laser-absorbing temporary adhesive layer 1 in a solvent is applied to the laser-transmitting substrate 1, followed by heating and curing to prepare the laser-absorbing temporary adhesive layer 1. The laminate including a single laser-absorbing temporary adhesive layer 1 on the laser-transmitting substrate 1 in this way is hereinafter referred to as a laminate α. In the case of preparing the laser-absorbing temporary adhesive layer 1 by using a coating method, any coating method can be selected, and examples thereof include methods such as spin-coating using a spinner, spray-coating, roll-coating, and slit die-coating. The laser-absorbing temporary adhesive layer 1 after application is preferably dried in a range of 50°C to 150°C for one minute to several tens of minutes by using a hot plate, a drying oven, infrared rays, or the like. Thereafter, if necessary, the dried laser-absorbing temporary adhesive layer 1 is further heated and cured in a range of 100°C to 500°C for several minutes to several hours. The thickness of the laser-absorbing temporary adhesive layer 1 at this time is preferably 1.0 µm or more and 30 µm or less. The thickness can be measured by using a scanning electron microscope, an optical thickness meter, a step meter, or the like.

In the case where the laser-absorbing temporary adhesive layer 1 includes the laser-absorbing layer 1 and the temporary adhesive layer 2, the laser-absorbing layer 1 and the temporary adhesive layer 2 can be produced by the same method as that for the laser-absorbing temporary adhesive layer 1 by respectively using a varnish obtained by dissolving material components of the laser-absorbing layer 1 in a solvent and a varnish obtained by dissolving material components of the temporary adhesive layer 2 in a solvent. The laminate including the laser-absorbing temporary adhesive layer 1, composed of two layers, i.e., the laser-absorbing layer 1 and the temporary adhesive layer 2, on the laser-transmitting substrate 1 in this way is hereinafter referred to as a laminate β.

The protective layer 1-attached semiconductor layer 1 can be directly arranged and laminated on the laser-absorbing temporary adhesive layer 1 or the temporary adhesive layer 2 in the laminate α or β by a mounter, a flip-chip mounting machine, or the like, and can also be pressure-bonded thereto by using a vacuum laminator, a wafer bonder, or a pressing machine as necessary.

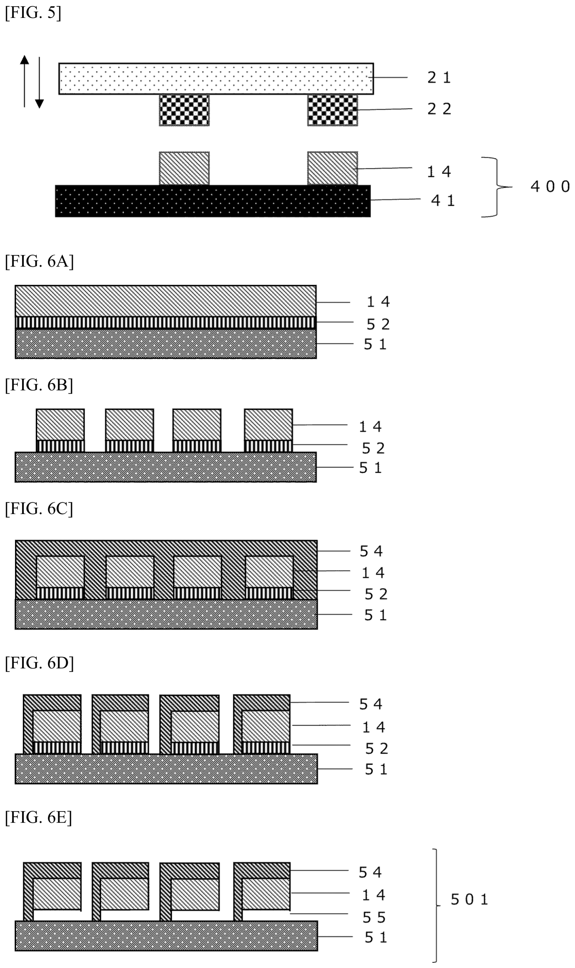

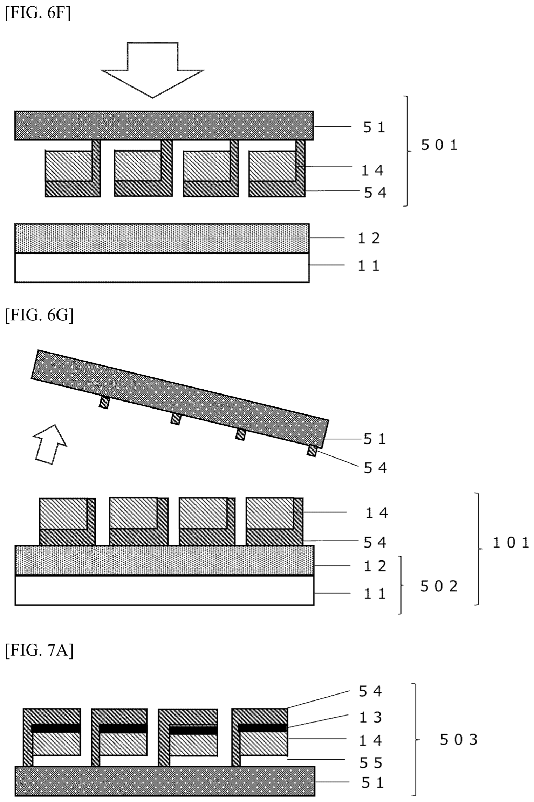

Alternatively, there is a lamination method as described in the above Non Patent Literature 2 (Jing Zhang et al., III-V-on-Si photonic integrated circuits realized using micro-transfer-printing, APL Photon., 2019, 4, 110803), and this lamination method is as follows. This lamination method will be described with reference to FIG. 6A, FIG. 6B, FIG. 6C, FIG. 6D, FIG. 6E, FIG. 6F, and FIG. 6G.

A sacrificial layer (reference numeral 52) and the semiconductor layer 1 (reference numeral 14) are formed in this order on a semiconductor wafer (reference numeral 51) (FIG. 6A), the semiconductor layer 1 (reference numeral 14) and the sacrificial layer (reference numeral 52) are divided into small pieces (FIG. 6B), and then a photoresist layer (reference numeral 54) is formed so as to cover the small pieces including the semiconductor layer 1 (reference numeral 14) and the sacrificial layer (reference numeral 52) (FIG. 6C). At this time, the photoresist layer (reference numeral 54) is partially patterned such that the sacrificial layer can be removed (FIG. 6D). Thereafter, the sacrificial layer (reference numeral 52) is removed by using a chemical solution, whereby a laminate 0" (reference numeral 501), which is a bridge structure, in which the semiconductor layer 1 (reference numeral 14) and the semiconductor wafer (reference numeral 51) are connected in a hollow (reference numeral 55) by using the photoresist layer (reference numeral 54) as a Thether, can be formed (FIG. 6E). Thereafter, a photoresist layer (reference numeral 54) side of the laminate 0" (reference numeral 501) is pressure-bonded to a laser-absorbing temporary adhesive layer 1 (reference numeral 12) side of the laminate α (reference numeral 502) formed by laminating the laser-absorbing temporary adhesive layer 1 (reference numeral 12) on the laser-transmitting substrate 1 (reference numeral 11), which has been separately prepared (FIG. 6F). Accordingly, the bridge structure of the photoresist layer (reference numeral 54) is damaged, the bridge structure of the photoresist layer (reference numeral 54) and the semiconductor wafer (reference numeral 51) are separated from each other, whereby a laminate 1' (reference numeral 101) in which the photoresist layer (reference numeral 54) and the semiconductor layer 1 (reference numeral 14) are laminated in this order on the laminate α (reference numeral 502), can be obtained (FIG. 6G). Note that, in the steps illustrated in FIG. 6F and FIG. 6G, the laminate β may be used instead of the laminate α. In this case, the photoresist side of the laminate 0" is pressure-bonded to a temporary adhesive layer 2 side of the laminate β, the bridge structure of the photoresist is damaged and separated, and the laminate 1' in which the photoresist and the semiconductor layer 1 are laminated in this order on the laminate β is obtained.

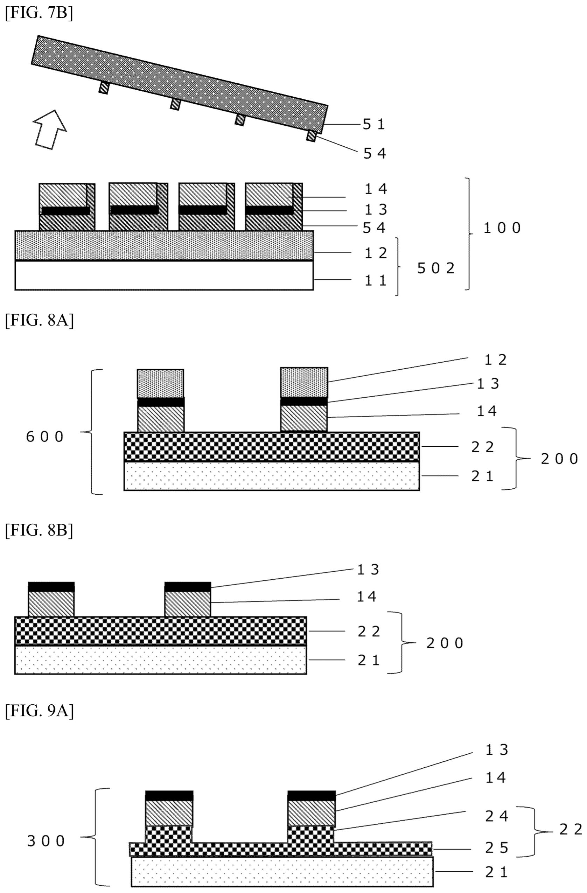

A laminate 0 (reference numeral 503), which is a bridge structure in a stage before the laminate 1 according to the present invention is obtained, can be produced by the same method as described above except that, as illustrated in FIGS. 7A and 7B, in the step of obtaining the laminate 0", the sacrificial layer (reference numeral 52), the semiconductor layer 1 (reference numeral 14), and the protective layer 1 (reference numeral 13) are formed in this order on the semiconductor wafer (reference numeral 51), the semiconductor layer 1 (reference numeral 14), the sacrificial layer (reference numeral 52), and the protective layer 1 (reference numeral 13) are divided into small pieces, and then the photoresist layer (reference numeral 54) is formed so as to cover the small pieces including the semiconductor layer 1 (reference numeral 14), the sacrificial layer (reference numeral 52), and the protective layer 1 (reference numeral 13) (FIG. 7A). Then, the photoresist layer (reference numeral 54) side of the laminate 0 (reference numeral 503), which is the bridge structure, is pressure-bonded to the laser-absorbing temporary adhesive layer 1 (reference numeral 12) side of the laminate α (reference numeral 502) by using the laminate 0 (reference numeral 503) instead of the laminate 0", whereby the bridge structure of the photoresist layer (reference numeral 54) is damaged, the bridge structure of the photoresist layer (reference numeral 54) and the semiconductor wafer (reference numeral 51) are separated from each other, and the laminate 1 (reference numeral 100) in which the photoresist layer (reference numeral 54), the protective layer 1 (reference numeral 13), and the semiconductor layer 1 (reference numeral 14) are laminated in this order on the laminate α (reference numeral 502) can be obtained (FIG. 7B).

In the case of using dry-etching to pattern the pressure-sensitive adhesive layer to be described later, the protective layer 1 can be used as a mask for the dry-etching. In this case, in the case where the protective layer 1 is a photoresist, a selection ratio of dry-etching rate is insufficient, and thus the protective layer 1 preferably includes an inorganic film having a dry-etching selection ratio with respect to the pressure-sensitive adhesive layer. The inorganic film is preferably formed immediately after the formation of the semiconductor layer 1 including an epitaxial crystal growth film. On the other hand, in the case where wet-etching is used for patterning the pressure-sensitive adhesive layer, the protective layer 1 is not limited to the above.

The pressure when laminating the protective layer 1-attached semiconductor layer 1 can be selected to an optimum value depending on the adhesive strength of the laser-absorbing temporary adhesive layer 1, and can be selected in a range of 0.05 MPa to 5.0 MPa. The pressure is preferably 2.0 MPa or less since the damages to the semiconductor layer 1 can be avoided and embedding of the semiconductor layer 1 in the laser-absorbing temporary adhesive layer 1 can be prevented. When the semiconductor layer 1 is laminated, the pressure can be applied while performing heating as necessary. By heating, the flexibility of the laser-absorbing temporary adhesive layer 1 is improved, and the semiconductor element can be pressure-bonded at a lower pressure.

In addition, by attaching an alignment mark to the laminate 1 in advance, it is easy to adjust a transfer position in the subsequent operations.

### [Laminate 2]

Next, as illustrated in FIG. 2A for example, the laminate 2 (reference numeral 200) in which a pressure-sensitive adhesive layer (reference numeral 22) is laminated on a support substrate 2 (reference numeral 21) will be described.

### (Support Substrate 2)

First, the support substrate 2 included in the laminate 2 will be described. The support substrate 2 is not particularly limited, and a substrate such as a glass, quartz, a silicon wafer, a sapphire substrate, a ceramic substrate, a metal substrate, a semiconductor substrate, or a ceramic substrate, or a circuit substrate in which a constituent material of a circuit is disposed on these substrates can be used. The thickness of the support substrate 2 is preferably 0.3 mm to 5 mm from the viewpoint of handling the substrate.

### (Pressure-Sensitive Adhesive Layer)

Next, the pressure-sensitive adhesive layer included in the laminate 2 will be described.

The pressure-sensitive adhesive layer has a pressure-sensitive adhesive property even after thermal curing, a curing treatment in which a crosslinking agent or a curing agent reacts, or the like, and an object held in the pressure-sensitive adhesive layer can be reversibly held and detached.

The pressure-sensitive adhesive layer is a resin layer having a pressure-sensitive adhesive property. Examples of the resin that can be contained in the pressure-sensitive adhesive layer include, but are not limited to, a resin having a glass transition temperature of 100°C or lower, such as a polyimide, a polyimide precursor, a polybenzoxazole, a polybenzoxazole precursor, a urethane resin, a novolac resin, a polyhydroxystyrene, a polyester resin, an acrylic resin, an aramid resin, a silicone, and a polyimide silicone resin.

The pressure-sensitive adhesive layer adheres, in a pressure-sensitive manner, to the semiconductor layer 1 in forming a laminate 3. It is preferable that the pressure-sensitive adhesive layer has heat resistance and mechanical properties that allow the semiconductor layer 1 to be directly bonded to a circuit substrate in a state where the pressure-sensitive adhesive layer and the semiconductor layer 1 adhere to each other in a pressure-sensitive manner during production of a semiconductor device thereafter. The heat resistance is preferably 200°C or higher, and more preferably 250°C or higher. The heat resistance means the 1% mass loss temperature of a cured film of the pressure-sensitive adhesive layer. "Having mechanical properties" means that when directly bonding the semiconductor layer 1 to a circuit substrate at a high temperature, protrusion due to melting of the pressure-sensitive adhesive layer does not adversely influence the direct bonding.

The elastic modulus of the pressure-sensitive adhesive layer at 200°C is preferably 0.1 MPa or more, more preferably 0.3 MPa, and still more preferably 0.5 MPa or more. Since solvent etching of the semiconductor layer 1 and removal of the photoresist or the protective layer 1 may be performed in a state where the pressure-sensitive adhesive layer and the semiconductor layer 1 adhere to each other in a pressure-sensitive manner, it is preferable that the pressure-sensitive adhesive layer has chemical resistance. Examples of the solvent to be used include acids such as hydrofluoric acid, buffered hydrofluoric acid, hydrochloric acid, sulfuric acid, iron chloride, and SC-2 (a hydrochloric acid hydrogen peroxide aqueous solution), which are etching solvents, a resist solvent, a developing solution (2.38% TMAH), SC-1 (an ammonia hydrogen peroxide aqueous solution), and a resist stripping solvent.

The elastic modulus can be calculated by dynamic viscoelasticity (DMA) measurement, and details thereof are as described in Examples to be described later.

Base on the above properties, the pressure-sensitive adhesive layer preferably contains a polyimide-based resin.

The polyimide-based resin preferably contains a polyimide copolymer (A) containing at least an acid dianhydride residue and a diamine residue. The diamine residue preferably contains a diamine residue (A0) represented by a formula (10), in which n is a natural number of preferably 1 or more and 100 or less, and more preferably 1 or more and 50 or less. It is preferable that the diamine residue (A0) is contained in an amount of 50.0 mol% to 95.0 mol% in 100.0 mol% of all diamine residues in the polyimide copolymer (A).

Further, the polyimide copolymer (A) preferably contains a diamine residue (A3) having a phenolic hydroxy group, and preferably contains the diamine residue (A3) in an amount of 1.0 mol% to 30.0 mol% with respect to 100.0 mol% of all the diamine residues in the polyimide copolymer (A).

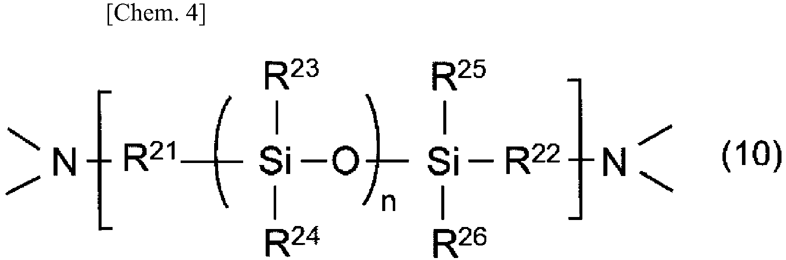

In the formula (10), R²¹ and R²² may be the same as or different from each other, and each represent an alkylene group having 1 to 30 carbon atoms or a phenylene group. R²³ to R²⁶ may be the same as or different from each other, and each represent an alkyl group having 1 to 30 carbon atoms, a phenyl group, or a phenoxy group.

The polyimide copolymer (A) contains an acid dianhydride residue and a diamine residue, and can be prepared by copolymerizing these residues. In order to impart the pressure-sensitive adhesive property at room temperature, it can be prepared by copolymerizing the diamine residue (A0) as a diamine component. The polyimide copolymer (A) may be prepared by copolymerizing a diamine containing the diamine residue (A0) and another diamine containing the diamine residue (A3).

Further, by copolymerizing the diamine residue (A3) in addition to the diamine residue (A0), the polyimide copolymer (A) can be crosslinked with a crosslinking agent to be described later. In addition, due to an effect of a hydrogen bond of the hydroxy group in the diamine residue (A3), an effect of keeping the elastic modulus constant in heating the pressure-sensitive adhesive layer is obtained.

The polyimide copolymer (A) constituting the pressure-sensitive adhesive layer preferably contains the diamine residue (A0) in an amount of 50.0 mol% to 95.0 mol% in 100.0 mol% of all the diamine residues. In the case where the diamine residue (A0) is contained in an amount of 50.0 mol% or more, the pressure-sensitive adhesive layer exhibits a good pressure-sensitive adhesive property, and the semiconductor layer 1 can be laminated on the pressure-sensitive adhesive layer with a high probability. In the case where the diamine residue (A0) is 95.0 mol% or less with respect to 100 mol% of all the diamine residues, temporal stability of the pressure-sensitive adhesive layer is improved, and a positional deviation of the semiconductor layer 1 when being stored in the state of the laminate 3 to be described later can be reduced. The diamine residue (A0) is more preferably contained in an amount of 80.0 mol% to 93.0 mol% in 100.0 mol% of all the diamine residues. In the case of 80 mol% or more, the pressure-sensitive adhesive layer exhibits good flexibility, and when the semiconductor layer 1 is transferred from the laminate 1 by using a laser to be described later, the semiconductor layer 1 can be laminated with high positional accuracy. In the case of 93 mol% or less, the step of applying heat or pressure such as direct bonding can be passed through.

In addition, the polyimide copolymer (A) constituting the pressure-sensitive adhesive layer according to the present embodiment preferably contains the diamine residue (A3) having a phenolic hydroxy group. In the case where the polyimide copolymer (A) contains the diamine residue (A3), the hydroxy group in the diamine (A3) is hydrogen-bonded, so that the elastic modulus at a high temperature can be kept constant, and protrusion of the pressure-sensitive adhesive layer in the direct bonding step can be prevented. In addition, in the case of adding a crosslinking agent, the resin on the surface of the pressure-sensitive adhesive layer is crosslinked, and when the semiconductor layer 1 laminated on the pressure-sensitive adhesive layer is to be separated from the pressure-sensitive adhesive layer, cohesive failure of the pressure-sensitive adhesive layer is reduced, and the adhesive residue on the surface of the semiconductor layer 1 can be reduced. The adhesive residue in this case refers to a residue of the pressure-sensitive adhesive layer on the surface of the semiconductor layer 1 after the semiconductor 1 is separated.

The content of the diamine residue (A3) having a phenolic hydroxy group is preferably 1.0 mol% to 30.0 mol% with respect to 100.0 mol% of all the diamine residues in the polyimide copolymer (A). Accordingly, while the semiconductor element is stably held by stabilizing the elastic modulus at a high temperature, in the case where the semiconductor element is further crosslinked with the crosslinking agent, the adhesive residue reducing effect is improved.

The content of the diamine residue (A3) having a phenolic hydroxy group is more preferably 5.0 mol% to 20.0 mol% with respect to 100.0 mol% of all the diamine residues in the polyimide copolymer (A). In the case where the polyimide copolymer (A) contains the diamine residue (A3) having a phenolic hydroxy group in an amount of 5.0 mol% or more with respect to 100.0 mol% of all the diamine residues in the polyimide copolymer (A), the crosslinking on the film surface proceeds uniformly, so that the adhesive residue is further reduced and the chemical resistance is also improved. In addition, in the case where the polyimide copolymer (A) contains the diamine residue (A3) in an amount of 20.0 mol% or less with respect to 100.0 mol% of all the diamine residues in the polyimide copolymer (A), the semiconductor element can be stably held.

Specific examples of the diamine residue (A3) having a phenolic hydroxy group include bisaminophenol derivative residues listed as specific examples in the case where R⁷ and R⁹(OH)₂ in the formula (3) and the formula (4) described above in the description of the laser-absorbing temporary adhesive layer 1 represent a bisaminophenol derivative residue.

Further, the polyimide copolymer (A) may contain a diamine residue other than the diamine residue (A0) and the diamine residue (A3) having a phenolic hydroxy group. The diamine residue other than the diamine residue (A0) and the diamine residue (A3) having a phenolic hydroxy group is preferably contained in an amount of 0.1 mol% or more and 40.0 mol% or less in 100.0 mol% of all the diamine residues in the polyimide copolymer (A).

Specific examples of the diamine residue other than the diamine residue (A0) and the diamine residue (A3) include residues of p-phenylenediamine, 9,9-bis(4-aminophenyl)fluorene, 4'-bis(4-aminophenoxy)biphenyl, 4,4'-diaminodiphenyl ether, 4,4'-diaminodiphenyl sulfone, 4,4'-diaminobenzophenone, 2,2-bis[4-(4-aminophenoxy)phenyl]propane, and 2,2-bis[4-(4-aminophenoxy)phenyl]hexafluoropropane. The polyimide copolymer (A) may contain only one kind of the diamine residue other than the diamine residue (A0) and the diamine residue (A3), or may contain two or more kinds thereof.

The polyimide copolymer (A) contains an acid dianhydride residue, and preferably contains a residue of an aromatic tetracarboxylic acid dianhydride. As the acid dianhydride residue, a known acid dianhydride residue can be contained. Specific examples of the residue of the aromatic tetracarboxylic acid dianhydride include examples of the tetracarboxylic acid residue constituting R¹ or R³(COOR⁵)₂ in the formula (1) and the formula (2) described above in the description of the laser-absorbing temporary adhesive layer 1. The polyimide copolymer (A) may contain only one kind of the residue of the aromatic tetracarboxylic acid dianhydride, or may contain two or more kinds thereof.

In addition, the polyimide copolymer (A) may contain a residue of a tetracarboxylic acid dianhydride having an aliphatic ring to the extent that the heat resistance of the polyimide copolymer (A) is not impaired. Specific examples of the residue of the tetracarboxylic acid dianhydride having an aliphatic ring include residues of 1,2,3,4-cyclobutanetetracarboxylic acid dianhydride and 1,2,3,4-cyclopentanetetracarboxylic acid dianhydride. The polyimide copolymer (A) may contain only one kind of the residue of the tetracarboxylic acid dianhydride, or may contain two or more kinds thereof.

The weight average molecular weight of the polyimide copolymer (A) is preferably 500 to 1,000,000 from the viewpoint of the pressure-sensitive adhesive property. The weight average molecular weight is a value measured by gel permeation chromatography (hereinafter sometimes abbreviated as GPC) and converted into polystyrene equivalent.

The molecular weight of the polyimide copolymer (A) can be adjusted by using equimolar amount of the acid dianhydride component and the diamine component used for synthesis, or by using excessive amount of either of them. The molecular weight can be also adjusted by making either the acid dianhydride component or the diamine component excessive and blocking a polymer chain terminal with a terminal blocking agent such as an acid component or an amine component. As the terminal blocking agent as an acid component, a dicarboxylic acid or an anhydride thereof is preferably used, and as the terminal blocking agent as an amine component, a monoamine is preferably used. At this time, an acid equivalent of the tetracarboxylic acid component and an amine equivalent of the diamine component, including the terminal blocking agent as an acid component or an amine component, are preferably equimolar.

As the monoamine that can be used as the terminal blocking agent as an amine component, known monoamines can be used, and among these, aniline, aminophenol, and the like are preferred. Two or more kinds of these may be used as the terminal blocking agent as an amine component.

In addition, the terminal blocking agent as an acid component is preferably a monocarboxylic acid, a monoacid chloride compound, or a mono-active ester compound, for example, acid anhydrides such as phthalic acid anhydride, maleic acid anhydride, nadic acid anhydride, or cyclohexanedicarboxylic acid anhydride, monocarboxylic acids such as 3-carboxyphenol, monoacid chloride compounds in which a carboxy group of these acids is converted into an acid chloride, monoacid chloride compounds in which only one carboxy group of a dicarboxylic acid such as phthalic acid or maleic acid is converted into an acid chloride, active ester compounds obtained by a reaction between a monoacid chloride compound and N-hydroxybenzotriazole, and the like. Two or more kinds of these may be used as the terminal blocking agent as an acid component.

The molar ratio of the acid dianhydride component to the diamine component in the polyimide copolymer (A) can be appropriately adjusted such that the viscosity of the resin composition is in a range easily used in coating or the like. The molar ratio of the acid dianhydride component to the diamine component is generally adjusted in a range of 100/100 to 100/95 or 100/100 to 95/100. In the case where the molar ratio of the acid dianhydride component to the diamine component in the polyimide copolymer (A) is out of the above range, the molecular weight of the resin decreases, a mechanical strength of the formed film decreases, and a pressure-sensitive adhesive force tends to be uneven, and thus it is preferable to adjust the molar ratio within a range in which the pressure-sensitive adhesive force is stable.

The polyimide copolymer (A) may be a polyimide precursor to be a polyimide copolymer by ring closure by heating, a polyimide copolymer obtained by ring closure by heating, or a polyimide precursor in which a part of the polyimide copolymer is ring-closed by heating.

A method for polymerizing the polyimide copolymer (A) is not particularly limited. For example, when a polyamide acid, which is a polyimide precursor, is subjected to polymerization, an acid dianhydride and a diamine are stirred in a solvent at 0°C to 100°C for 1 hour to 100 hours to obtain a polyamide acid resin solution. In the case where the polyimide resin is soluble in the solvent, after the polyamide acid is polymerized, the temperature is raised to 120°C to 300°C as it is, followed by stirring for 1 hour to 100 hours, to convert the polyamide acid into a polyimide, thereby obtaining a polyimide resin solution. At this time, toluene, o-xylene, m-xylene, p-xylene, or the like may be added to the reaction solution, and water generated by the imidization reaction may be removed by azeotropy with the solvent.

The pressure-sensitive adhesive layer may contain a crosslinking agent. Examples of the crosslinking agent include polyfunctional acrylic, polyfunctional epoxy, polyfunctional methylol compounds, and polyfunctional styrene compounds. A particularly preferred crosslinking agent is a dimer acid-modified epoxy resin. The dimer acid-modified epoxy resin has a structure in which a terminal of a dimer acid is epoxidized, and has a flexible skeleton. Therefore, even in the case where a crosslinking reaction occurs with the phenolic hydroxy group contained in the polyimide copolymer (A), the chemical resistance and the heat resistance can be improved without deteriorating the flexibility of the pressure-sensitive adhesive layer, which is preferred.

The dimer acid-modified epoxy resin is obtained by introducing a glycidyl group into a dibasic acid obtained by dimerizing an unsaturated fatty acid. Examples of the dimer acid-modified epoxy resin include oleic acid, elaidic acid, octadecenoic acid, linoleic acid, palmitoleic acid, myristoleic acid, linolenic acid, isooleic acid, eicosenoic acid, docosenoic acid, branched octadecenoic acid, branched hexadecenoic acid, and undecylenic acid. In addition, examples thereof include, but are not limited to, JER (registered trademark) 871 and JER (registered trademark) 872 (manufactured by Mitsubishi Chemical Group Corporation) and ERISYSGS-120 (manufactured by CVC Inc.) in which a glycidyl group is introduced into a dimer of linolenic acid.

A preferred addition amount of the crosslinking agent is 0.1 parts by mass to 20 parts by mass with respect to 100 parts by mass of the polyimide copolymer (A). In the case of 0.1 parts by mass or more, chemical resistance can be imparted to the pressure-sensitive adhesive layer. In the case of 20 parts by mass or less, the pressure-sensitive adhesive property and flexibility of the pressure-sensitive adhesive layer can be appropriately maintained, and the semiconductor layer 1 can be stably held in the state of the laminates 3 and 4 to be described later.

The pressure-sensitive adhesive layer may contain a curing accelerator as necessary in order to promote curing of the polyimide copolymer (A) and the crosslinking agent.

Examples of the curing accelerator include imidazoles, tertiary amines or salts thereof, and organic boron salt compounds, and among these, imidazoles are preferred. Specific examples of the imidazoles include imidazole, 1,2-dimethylimidazole, 2-ethyl-4-methylimidazole, 2-phenyl-1H-imidazole, 2,4-diamino-6-[2'-ethyl-4-methylimidazolyl-(1')]-ethyl-s-triazine, and a 2-methylimidazole isocyanuric acid adduct. In addition, examples of preferred commercially available products of the imidazoles include CUREZOL (registered trademark) 2E4MZ and CUREZOL (registered trademark) 2E4MZ-CN (manufactured by SHIKOKU CHEMICALS CORPORATION).

A preferred addition amount of the curing accelerator is 0.1 parts by mass to 5.0 parts by mass with respect to 100 parts by mass of the polyimide copolymer (A). A more preferred content of the curing accelerator is 0.3 parts by mass to 1.0 parts by mass with respect to 100 parts by mass of the polyimide copolymer (A). In the case where the addition amount of the curing accelerator is within this range, a sufficient crosslinking promoting effect is obtained, and the stability of the pressure-sensitive adhesive layer is improved.

In addition, the pressure-sensitive adhesive layer may contain an imidization accelerator. In the case where the polyimide copolymer (A) is a polyamide acid resin, the polyamide acid resin can be converted into a polyimide resin by heating at a low temperature in a short period of time using an imidization accelerator. The heat resistance is improved by converting the polyamide acid resin into the polyimide resin.

Specific examples of the imidization accelerator include, but are not limited to, pyridine, β-picoline, quinoline, imidazole, 2-methylimidazole, 1,2-dimethylimidazole, 2-phenylimidazole, triethylamine, m-hydroxybenzoic acid, 4-hydroxyphenylpropionic acid, p-phenolsulfonic acid, p-aminophenol, and p-aminobenzoic acid.

The content of the imidization accelerator is preferably 3 parts by mass or more and 10 parts by mass or less with respect to 100 parts by mass of the polyimide copolymer (A). In the case where the content of the imidization accelerator is within this range, the imidization can be completed even by a heat treatment at a lower temperature, the amount of the imidization accelerator remaining in the pressure-sensitive adhesive layer after the heat treatment can be minimized, and generation of volatile components can be prevented. The imidization accelerator may be added during the polymerization of the polyimide copolymer (A) or after the polymerization.

The pressure-sensitive adhesive layer may contain an ultraviolet absorber or a dye. Accordingly, it is possible to peel the substrate by using a laser in a substrate-peeling step (VI) to be described later. Preferred examples of the ultraviolet absorber and the dye to be used in the pressure-sensitive adhesive layer are the same as those described above for the laser-absorbing temporary adhesive layer 1.

The thickness of the pressure-sensitive adhesive layer formed on the support substrate 2 is preferably 1.0 µm to 30 µm. In the case where the thickness of the pressure-sensitive adhesive layer is 1.0 µm or more, the transferred semiconductor layer 1 can be laminated on the pressure-sensitive adhesive layer in the step of transferring the semiconductor layer 1 by laser irradiation to be described later. In addition, in the case where the thickness of the pressure-sensitive adhesive layer is 30 µm or less, unevenness in in-plane uniformity of the pressure-sensitive adhesive layer is reduced, and the semiconductor element can be uniformly held. A more preferred range of the thickness of the pressure-sensitive adhesive layer is 2.5 µm to 10 µm. In the case where the thickness of the pressure-sensitive adhesive layer is 2.5 µm or more, the semiconductor layer 1 can be laminated on the pressure-sensitive adhesive layer with high positional accuracy in the step of laser transfer of the semiconductor layer 1. In addition, in the case where the thickness of the pressure-sensitive adhesive layer is 10 µm or less, it is possible to reduce bonding failure due to the protrusion of the pressure-sensitive adhesive layer or the positional deviation of the semiconductor layer 1 due to a flow of the pressure-sensitive adhesive layer in a direct bonding step to be described later.

The thickness of the pressure-sensitive adhesive layer can be measured by using a scanning electron microscope, an optical thickness meter, a step meter, a laser microscope, or the like.

The laser-absorbing layer 2 described above may be provided between the support substrate 2 and the pressure-sensitive adhesive layer. At this time, for example, as illustrated in FIG. 2B, the laminate 2 (reference numeral 200) is obtained by laminating the laser-absorbing layer 2 (reference numeral 23) and the pressure-sensitive adhesive layer (reference numeral 22) in this order on the support substrate 2 (reference numeral 21). Accordingly, a peeling method using a laser can be applied in the substrate-peeling step in the step (VI) to be described later. The detailed description of the laser-absorbing layer 2 is the same as the description of the laser-absorbing layer 1 described above.

Examples of a method for forming the pressure-sensitive adhesive layer on the support substrate 2 include a method of coating the support substrate 2 with a varnish obtained by dissolving the above components that can be contained in the pressure-sensitive adhesive layer in a solvent. After the coating, heating and curing may be performed.

### [Method for Producing Laminate 2]

Next, a method for producing the laminate 2 will be described in detail.

The laminate 2 can be produced by forming the pressure-sensitive adhesive layer on the support substrate 2.

An example of the method for preparing the laminate 2 will be described.

The pressure-sensitive adhesive layer can be formed by coating the support substrate 2 with a varnish obtained by dissolving the above components that can be contained in the pressure-sensitive adhesive layer in a solvent, followed by heating and curing. In the case of preparing the pressure-sensitive adhesive layer by using a coating method, any coating method can be selected, and examples thereof include methods such as spin-coating using a spinner, spray-coating, roll-coating, and slit die-coating. The pressure-sensitive adhesive layer after application is preferably dried in a range of 50°C to 150°C for one minute to several tens of minutes by using a hot plate, a drying oven, infrared rays, or the like. Thereafter, if necessary, the dried pressure-sensitive adhesive layer is further heated and cured in a range of 100°C to 500°C for several minutes to several hours. The thickness of the pressure-sensitive adhesive layer at this time is preferably 1.0 µm to 30 µm. The thickness can be measured by using a scanning electron microscope, an optical thickness meter, a step meter, or the like.

In the case where the laser-absorbing layer 2 is provided between the support substrate 2 and the pressure-sensitive adhesive layer, the laser-absorbing layer 2 is formed on the support substrate 2, and the pressure-sensitive adhesive layer is further formed thereon.

### [Method for Producing Laminate 3]

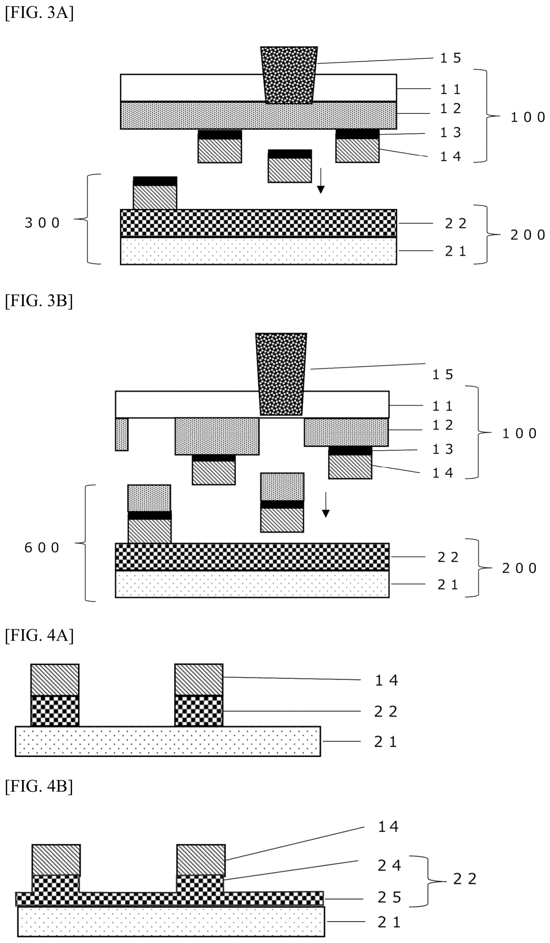

Next, for example, as illustrated in FIG. 3A, the laminate 3 (reference numeral 300) in which the pressure-sensitive adhesive layer (reference numeral 22), the semiconductor layer 1 (reference numeral 14), and the protective layer 1 (reference numeral 13) are laminated in this order on the support substrate 2 (reference numeral 21), which is one embodiment of the present invention, will be described.

The laminate 3 is preferably a laminate including the support substrate 2, the pressure-sensitive adhesive layer, the semiconductor layer 1, and the protective layer 1 laminated in this order, in which the pressure-sensitive adhesive layer has a patterned shape.

An example of a method for producing the laminate 3 will be described, but the present invention is not limited to this example.

For example, as illustrated in FIG. 3A, the following steps are performed in this order:
the step (I) of using the laminate 1 (reference numeral 100), in which the laser-absorbing temporary adhesive layer 1 (reference numeral 12), the protective layer 1 (reference numeral 13), and the semiconductor layer 1 (reference numeral 14) are laminated in this order on the laser-transmitting substrate 1 (reference numeral 11), and the laminate 2 (reference numeral 200), in which the pressure-sensitive adhesive layer (reference numeral 22) is laminated on the support substrate 2 (reference numeral 21), to cause a surface of the laminate 1 (reference numeral 100) on a semiconductor layer 1 (reference numeral 14) side and a surface of the laminate 2 (reference numeral 200) on a pressure-sensitive adhesive layer (reference numeral 22) side to face each other, and
the step (II) of subjecting the laser-absorbing temporary adhesive layer 1 (reference numeral 12) to laser irradiation (reference numeral 15) from a surface side of the laminate 1 (reference numeral 100) opposite to the surface thereof on the semiconductor layer 1 (reference numeral 14) side while transmitting the laser through the laser-transmitting substrate 1 (reference numeral 11), and transferring the structure 1 in which the protective layer 1 (reference numeral 13) and the semiconductor layer 1 (reference numeral 14) are laminated to the laminate 2 (reference numeral 200) to form the laminate 3 (reference numeral 300).

Accordingly, the laminate 3 (reference numeral 300) in which the support substrate 2 (reference numeral 21), the pressure-sensitive adhesive layer (reference numeral 22), the semiconductor layer 1 (reference numeral 14), and the protective layer 1 (reference numeral 13) are laminated in this order can be obtained.

In the step (I), the laminate 1 and the laminate 2 prepared by the above methods are preferably fixed to each other such that the surface of the laminate 1 on the semiconductor layer 1 side and the surface of the laminate 2 on the pressure-sensitive adhesive layer side face each other and the laminate 1 and the laminate 2 are parallel to each other. In order to prevent the positional deviation of the semiconductor layer 1 due to its own weight during the transfer, the laminate 1 and the laminate 2 facing each other are preferably disposed such that the laminate 1 faces upward. The laminate 1 and the laminate 2 are disposed at a constant interval, and the interval between the semiconductor layer 1 in the laminate 1 and the pressure-sensitive adhesive layer in the laminate 2 can be selected according to the size and the thickness of the semiconductor layer 1, and is preferably in a range of 0 µm to 100 µm.

In the case where the semiconductor layer 1 is a thin film having a thickness of 10 µm or less, the thin film semiconductor layer 1 may be damaged even by a small impact generated during the laser irradiation. Therefore, the laser-absorbing temporary adhesive layer 1 preferably has a structure of two or more layers including the laser-absorbing layer 1 and the temporary adhesive layer 2.

In addition, the laser-transmitting substrate 1 and the support substrate 2 may be provided with an alignment mark for transfer alignment.

Next, the step (II) will be described.

In the laminate 1 and the laminate 2 disposed in the step (I) described above, the laser-absorbing temporary adhesive layer 1 is irradiated with a laser from the surface side of the laminate 1 opposite to the surface thereof on the semiconductor layer 1 side while transmitting the laser through the laser-transmitting substrate 1.

The laminate 3 produced in the step (II) may include a layer other than the protective layer 1, the semiconductor layer 1, the pressure-sensitive adhesive layer, and the support substrate 2. In particular, when the structure 1 in which the protective layer 1 and the thin film semiconductor layer 1 are laminated is to be transferred in the step (II), for example, as illustrated in FIG. 3B, it is preferable that at least the laser-absorbing temporary adhesive layer 1 (reference numeral 12), the protective layer 1 (reference numeral 13), and the semiconductor layer 1 (reference numeral 14) are integrated and simultaneously transferred to form a laminate 4 (reference numeral 600) in which the pressure-sensitive adhesive layer (reference numeral 22), the semiconductor layer 1 (reference numeral 14), the protective layer 1 (reference numeral 13), and the laser-absorbing temporary adhesive layer 1 (reference numeral 12) are laminated in this order on the support substrate 2 (reference numeral 21) since the thin film semiconductor layer 1 (reference numeral 14) can be transferred without damages.

Examples of the kind of the laser include solid-state lasers such as a YAG laser, a YVO4 laser, a fiber laser, and a semiconductor laser, and gas lasers such as a carbon dioxide laser, an excimer laser, and an argon laser, which can be selected according to the wavelength to be used. The beam shape of the laser for irradiation is not limited, and the spot size of the laser may be smaller than the size of the semiconductor layer 1. However, it is preferable to have such a spot size that the laser does not hit the semiconductor layer 1 adjacent to the semiconductor layer 1 to be transferred. The laser can be selected with any energy amount. The energy amount of the laser is preferably 1 mJ/cm² or more from the viewpoint of stability of the energy amount of the laser, and is preferably 1,000 mJ/cm² or less from the viewpoint of preventing the damages to the semiconductor layer 1 and shortening the treatment time. The energy amount of the laser is more preferably 10 mJ/cm² or more and 500 mJ/cm² or less.

By using the laminate 1 according to the embodiment of the present invention, the transfer can be performed even at a low laser irradiation energy, and further, even in the case where the irradiation energy amount of the laser is changed, the influence on the positional accuracy can be reduced.

In the step (II), when the structure in which the protective layer 1 and the semiconductor layer 1 are laminated is to be transferred to the laminate 2, the laminate 2 may be heated. By heating the laminate 2, a retention property of the semiconductor layer 1 on the pressure-sensitive adhesive layer is improved after the transfer. In the case of heating the laminate 2, the heating temperature is preferably 100°C or lower since warpage of the laminate 2 due to heat can be prevented and the transfer can be performed with high positional accuracy.

The transfer of the structure in which the protective layer 1 and the semiconductor layer 1 are laminated to the laminate 2 in the step (II) is preferably performed while adjusting the position according to an actual mounting position of the semiconductor layer 1 in the semiconductor device to be produced.

For example, in the case of producing a device for Si photonics, the transfer to the laminate 2 is performed while shifting a pitch of the semiconductor layer 1 according to a waveguide size and disposition of an optical circuit substrate. Next, the laminate 3 to which the semiconductor layer 1 has been transferred and the optical circuit substrate are made face each other, and the semiconductor layer 1 is pressure-bonded and transferred to the circuit substrate, whereby the optical circuit substrate on which the semiconductor layer 1 is mounted can be produced.

In the step (II), as illustrated in FIG. 8A, in the case of forming the laminate 4 (reference numeral 600) in which the pressure-sensitive adhesive layer (reference numeral 22), the semiconductor layer 1 (reference numeral 14), the protective layer 1 (reference numeral 13), and the laser-absorbing temporary adhesive layer 1 (reference numeral 12) are laminated in this order on the support substrate 2 (reference numeral 21), which is obtained by transferring a structure 2 in which the laser-absorbing temporary adhesive layer 1 (reference numeral 12), the protective layer 1 (reference numeral 13), and the semiconductor layer 1 (reference numeral 14) are laminated to the laminate 2 (reference numeral 200), the laser-absorbing temporary adhesive layer 1 (reference numeral 12) is then removed from the laminate 4 (reference numeral 600) (FIG. 8B). The removal of the laser-absorbing temporary adhesive layer 1 may be performed by wet cleaning with a solvent, a peeling liquid, or the like, or may be performed by dry-etching. At this time, a step (III') of removing a part of the pressure-sensitive adhesive layer to pattern the pressure-sensitive adhesive layer, which is to be described later, is also preferably performed collectively since the step can be simplified.

The method for producing the laminate 3 according to the embodiment of the present invention preferably includes the step (III) of removing a part of the pressure-sensitive adhesive layer in the laminate 3 obtained in the step (II) of constituting the laminate 3 and patterning the pressure-sensitive adhesive layer.

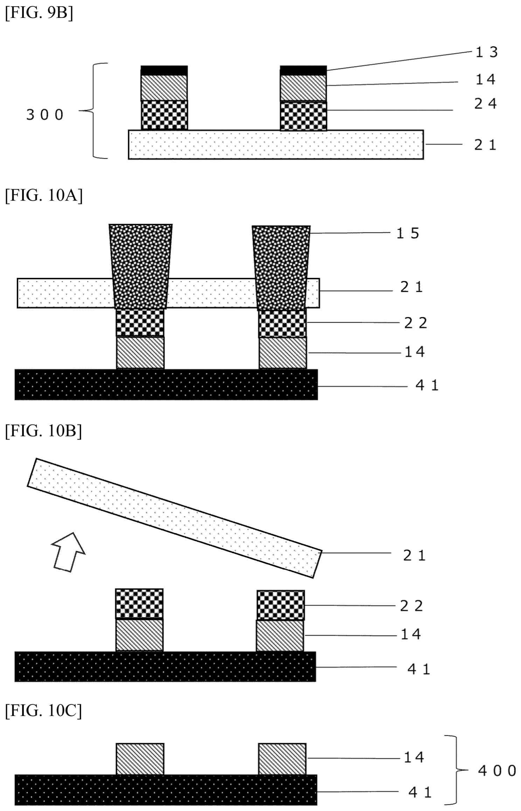

The laminate 3 preferably has a shape in which a part of the pressure-sensitive adhesive layer is removed and the pressure-sensitive adhesive layer is patterned. The patterning referred to here means that, as illustrated in FIG. 9A, in the pressure-sensitive adhesive layer (reference numeral 22), there is a difference in thickness between a pressure-sensitive adhesive layer (reference numeral 24) present between the semiconductor layer 1 (reference numeral 14) and the support substrate 2 (reference numeral 21) and a pressure-sensitive adhesive layer (reference numeral 25) on a portion of the support substrate 2 (reference numeral 21) not having the semiconductor layer 1 (reference numeral 14). At this time, the difference in thickness between the pressure-sensitive adhesive layer (reference numeral 24) present between the semiconductor layer 1 (reference numeral 14) and the support substrate 2 (reference numeral 21) and the pressure-sensitive adhesive layer (reference numeral 25) on the portion of the support substrate 2 (reference numeral 21) not having the semiconductor layer 1 (reference numeral 14) is preferably at least 0.5 µm or more or more. In particular, as illustrated in FIG. 9B, the laminate 3 (reference numeral 300) preferably includes only the pressure-sensitive adhesive layer (reference numeral 24) present between the semiconductor layer 1 (reference numeral 14) and the support substrate 2 (reference numeral 21) as the pressure-sensitive adhesive layer. That is, in the laminate 3, the pressure-sensitive adhesive layer other than the portion between the semiconductor layer 1 and the support substrate 2 is preferably removed. The protective layer 1 is preferably removed from the laminate 3 simultaneously with or after the removal of the pressure-sensitive adhesive layer, to expose the surface of the semiconductor layer 1. This is to facilitate the bonding between the laminate 3 and the circuit substrate and the removal of a pressure-sensitive adhesive layer-attached support substrate 2 in the subsequent steps (V) and (VI) after the next step.

Note that, a step of removing a part of the pressure-sensitive adhesive layer in the laminate 4 and patterning the pressure-sensitive adhesive layer is also referred to as the step (III').

The method for producing the laminate 3 according to the embodiment of the present invention preferably includes, in the step (III) of removing a part of the pressure-sensitive adhesive layer in the laminate 3 and patterning the pressure-sensitive adhesive layer, a step (III-A) of performing dry-etching or wet-etching on the pressure-sensitive adhesive layer in the laminate 3 by using the semiconductor layer 1 or the protective layer 1 in the laminate 3 as a mask. Note that, in the case where the laminate 3 is the laminate 4, the method for producing the laminate 3 according to the embodiment of the present invention preferably includes a step (III'-A) of performing dry-etching or wet-etching on the pressure-sensitive adhesive layer in the laminate 4 by using the semiconductor layer 1, the protective layer 1, or the laser-absorbing temporary adhesive layer 1 in the laminate 4 as a mask.

The dry-etching and the wet-etching are not particularly limited as long as the conditions allow the pressure-sensitive adhesive layer to be removed. In the dry-etching, in order to prevent the damages to the semiconductor layer 1, the dry-etching is preferably performed in a state where the protective layer 1 remains on the semiconductor layer 1.

It is preferable that the kind of the gas to be used in the dry-etching has a selection ratio of a dry-etching rate with respect to the protective layer 1. For example, a CF-based or SF-based fluorine-based gas or oxygen gas is preferable, and a fluorine-based gas, particularly, a mixture of oxygen gas and at least one of CF₄ or CHF₃ is more preferable since a high dry-etching rate can be achieved at a high selection ratio. As a ratio of the fluorine-based gas to oxygen gas, the oxygen concentration (vol%) in the entire gas is preferably 5% to 98%, more preferably 50% to 95%, and still more preferably 75% to 90%. In the case where the oxygen concentration is less than 5 vol%, the etching rate of an organic resin-based component in the protective layer 1 may be insufficient, and in the case where the oxygen concentration is more than 98 vol%, the etching rate of an inorganic component (particularly, silicon, siloxane, or silicone-based composition) may be insufficient.

The chemical solution to be used for the wet-etching is not particularly limited as long as the chemical solution dissolves the pressure-sensitive adhesive layer and does not damage the semiconductor layer 1. Specific examples thereof include a solvent used as a solvent of the resin component in the pressure-sensitive adhesive layer in forming the pressure-sensitive adhesive layer, and a resist-peeling liquid. At this time, in the case where the laminate 3 has a structure including the laser-absorbing temporary adhesive layer 1 and a photoresist, they may be removed at the same time.

The method for producing the laminate according to the embodiment of the present invention preferably includes the step (IV) of removing the protective layer 1 in the laminate 3. As described above, it is preferable to remove the protective layer 1 on the semiconductor layer 1 after removing the pressure-sensitive adhesive layer by dry-etching or wet-etching in the step (III-A) in order to proceed the direct bonding step of the semiconductor layer 1 in the next step. Here, in the case where the laminate 3 has a photoresist, the photoresist is preferably removed together with the protective layer 1. Note that, in the case where the laminate 3 is the laminate 4, the method for producing a laminate according to the embodiment of the present invention preferably includes a step of removing the laser-absorbing temporary adhesive layer 1 and the protective layer 1 from the laminate 4, and this step is also referred to as a step (IV').

The laser-absorbing temporary adhesive layer 1 and the photoresist can be collectively removed during the dry-etching or the wet-etching on the pressure-sensitive adhesive layer in the step (III-A). In addition, the photoresist can be peeled off by using a resist-peeling liquid for photoresist. The protective layer 1 can be removed with an etchant liquid that dissolves the protective layer 1. Examples of the etchant liquid include hydrofluoric acid and phosphoric acid.

### [Method for Producing Semiconductor Device]

In a method for producing a semiconductor device according to one embodiment of the present invention, for example, as illustrated in FIG. 5, a semiconductor device (reference numeral 400) is produced by the step (V) of causing a surface of the laminate obtained in the step (IV), in which the pressure-sensitive adhesive layer (reference numeral 22) and the semiconductor layer 1 (reference numeral 14) are laminated in this order on the support substrate 2 (reference numeral 21), which is obtained by removing the protective layer 1 from the laminate 3, on the semiconductor layer 1 (reference numeral 14) side to face a surface of a circuit substrate (reference numeral 41) on which a circuit is formed, and bonding the semiconductor layer 1 (reference numeral 14) in the laminate to the circuit substrate (reference numeral 41) by thermocompression-bonding. The method for producing a semiconductor device preferably includes, after the step (V), the step (VI) of removing the pressure-sensitive adhesive layer (reference numeral 22)-attached support substrate 2 (reference numeral 21) from a structure in which the semiconductor layer 1 in the laminate is bonded to the circuit substrate.

As described above, by patterning the pressure-sensitive adhesive layer in the laminate 3 in the step (III) and removing the protective layer 1 in the step (IV), bonding ability of the semiconductor layer 1 to the circuit substrate by the thermocompression-bonding can be improved in the step (V), and peelability between the pressure-sensitive adhesive layer and the semiconductor layer 1 can be improved in the step (VI). That is, by reducing the thickness of or completely removing the pressure-sensitive adhesive layer other than the pressure-sensitive adhesive layer immediately below the semiconductor layer 1 from the laminate 3 in the step (III), only the semiconductor layer 1 can be brought into contact with and bonded to the facing circuit substrate during the bonding by thermocompression-bonding in the step (V). In this way, a schematic cross-sectional view of the laminate in which the pressure-sensitive adhesive layer in the laminate 3 is patterned and the protective layer is removed has, for example, the patterned pressure-sensitive adhesive layer (reference numeral 22) and the semiconductor layer 1 (14) on the support substrate 2 (reference numeral 21) as illustrated in FIGS. 4A and 4B.

After the step (V), in the next step (VI), the pressure-sensitive adhesive layer-attached support substrate 2 is peeled off and removed from the semiconductor layer 1. Before the removal, the pressure-sensitive adhesive layer is immersed in a solvent to be swollen or dissolved, whereby the pressure-sensitive adhesive layer-attached support substrate 2 is easily peeled off and removed from the semiconductor layer 1. In order to accelerate the swelling or dissolution of the pressure-sensitive adhesive layer by the solvent immersion, it is preferable to pattern the pressure-sensitive adhesive layer in the step (III). This is because the solvent easily enters a space from which the pressure-sensitive adhesive layer has been removed by the patterning of the pressure-sensitive adhesive layer, and the swelling of the pressure-sensitive adhesive layer easily proceeds.

In the case where the pressure-sensitive adhesive layer has laser absorbability, as illustrated in FIG. 10A, the laser irradiation (reference numeral 15) may be performed from the support substrate 2 (reference numeral 21) side to peel off the support substrate 2 (reference numeral 21) from the semiconductor layer 1 (reference numeral 14) (FIG. 10B). In this case, by performing the patterning of the pressure-sensitive adhesive layer in (III), the support substrate 2 can also be peeled off by irradiating only a portion of the semiconductor layer 1 with the laser without irradiating the entire surface of the support substrate 2 with the laser. By removing the pressure-sensitive adhesive layer after removing the support substrate 2, the semiconductor device (reference numeral 400) in which the semiconductor layer 1 (reference numeral 14) is bonded to the circuit substrate (reference numeral 41) can be obtained (FIG. 8C). Similarly, in the case where the pressure-sensitive adhesive layer does not have laser absorbability and the laser-absorbing layer 2 is included between the support substrate 2 and the pressure-sensitive adhesive layer, the pressure-sensitive adhesive layer-attached support substrate 2 can be peeled off from the semiconductor layer 1 by laser irradiation from the support substrate 2 side. In this case, after the support substrate 2 is removed, the laser-absorbing layer 2 is removed together with the pressure-sensitive adhesive layer.

As described above, the semiconductor device can be produced by bonding the semiconductor layer 1 to the circuit substrate by thermocompression-bonding. The circuit substrate may be an SOI wafer on which an optical waveguide is formed, as described in Non Patent Literatures 1 to 3 (Alexander W. Fang et al., Electrically pumped hybrid AlGaInAs-silicon evanescent laser, OPTICS EXPRESS, 2006, Vol. 14, No. 20, p9203; Jing Zhang et al., III-V-on-Si photonic integrated circuits realized using micro-transfer-printing, APL Photon., 2019, 4, 110803; and LUO et al., Wafer-scale dies-transfer bonding technology for hybrid III/V-on-silicon photonic integrated circuit, IEEE JOURNAL OF SELECTED TOPICS IN QUANTUM ELECTRONICS, 2016, Vol. 22, No. 6, 8200612), or may be a substrate of Si, Cu, Al, or the like, in order to emphasize a heat dissipation property. As described in Non Patent Literatures 1 and 2 (Alexander W. Fang et al., Electrically pumped hybrid AlGaInAs-silicon evanescent laser, OPTICS EXPRESS, 2006, Vol. 14, No. 20, p9203; and Jing Zhang et al., III-V-on-Si photonic integrated circuits realized using micro-transfer-printing, APL Photon., 2019, 4, 110803), after the semiconductor layer 1 is transferred, a plurality of semiconductor layers 1 can be collectively processed on the circuit substrate.

The semiconductor layer 1-attached circuit substrate can be suitably used as a semiconductor device. As the semiconductor device, a semiconductor communication element, an image pickup element, an amplifier element, or the like is suitably used. These are suitable for a silicon photonic semiconductor device to which a silicon photonics technology is applied, such as high-speed communication and high-speed processing such as data center and machine learning, distance sensors (Lidar), health care (health monitor mounted on smart watch), and sensor applications for gas detection.

In the semiconductor device, after the semiconductor layer 1 is bonded to the circuit substrate in the step (V), the pressure-sensitive adhesive layer remaining after the step (VI) is preferably removed, but may not be removed. Since the pressure-sensitive adhesive layer has an insulating property, a short circuit in the circuit substrate can be prevented in the case where the pressure-sensitive adhesive layer remains in the semiconductor device. In the case of removing the pressure-sensitive adhesive layer, the pressure-sensitive adhesive layer can be dissolved in a solvent and removed, or can be subjected to dry-etching.

In the case of performing the transfer by thermocompression-bonding using the laminate according to the embodiment of the present invention, since the transfer can be performed with high positional accuracy, the semiconductor layer 1 can be transferred without a deviation from the circuit substrate on which the semiconductor layer 1 is finally mounted, and mounting defects caused by the positional deviation can be reduced.

A silicon photonic semiconductor device can be produced by mounting and integrating elements such as a light emitting element, a light receiver, and an optical modulator on a silicon substrate by using the above method for producing a semiconductor device. In addition, an embodiment of the present invention relates to a silicon photonic semiconductor device produced by transferring a compound semiconductor chip by using a laser transfer method, and a method for producing the same.

As described above, the following matters are disclosed in the present description.
[1] A laminate including: a laser-transmitting substrate 1; and a laser-absorbing temporary adhesive layer 1, a protective layer 1, and a semiconductor layer 1 laminated in this order on the laser-transmitting substrate 1.
[2] The laminate according to the above [1], in which the semiconductor layer 1 is a compound semiconductor.
[3] The laminate according to the above [2], in which the compound semiconductor is AlGaInAs, InGaAs, InP, InGaAsP, AlAs, InAs, GaAs, AlN, AlP, GaN, InN, or SiC.
[4] The laminate according to any one of the above [1] to [3], in which the protective layer 1 is at least one of an oxide film and a nitride film.
[5] The laminate according to the above [4], in which the protective layer 1 contains SiO₂.
[6] A method for producing a laminate, successively including:
   a step (I) of using a laminate 1, in which a laser-absorbing temporary adhesive layer 1, a protective layer 1, and a semiconductor layer 1 are laminated in this order on a laser-transmitting substrate 1, and a laminate 2, in which a pressure-sensitive adhesive layer is laminated on a support substrate 2, to cause a surface of the laminate 1 on a semiconductor layer 1 side and a surface of the laminate 2 on a pressure-sensitive adhesive layer side to face each other; and
   a step (II) of irradiating the laser-absorbing temporary adhesive layer 1 with a laser from a surface side of the laminate 1 opposite to the surface thereof on the semiconductor layer 1 side while transmitting the laser through the laser-transmitting substrate 1, and transferring a structure in which the protective layer 1 and the semiconductor layer 1 are laminated to the laminate 2 to form a laminate 3 in which the pressure-sensitive adhesive layer, the semiconductor layer 1, and the protective layer 1 are laminated in this order on the support substrate 2.
[7] The method for producing a laminate according to the above [6], in which
   in the step (II),
   the structure 1 is a structure 2 in which the laser-absorbing temporary adhesive layer 1, the protective layer 1, and the semiconductor layer 1 are laminated, and
   the laminate 3 is a laminate 4 in which the pressure-sensitive adhesive layer, the semiconductor layer 1, the protective layer 1, and the laser-absorbing temporary adhesive layer 1 are laminated in this order on the support substrate 2.
[8] The method for producing a laminate according to the above [6] or [7], further including:
   a step (III) of removing a part of the pressure-sensitive adhesive layer in the laminate 3 and patterning the pressure-sensitive adhesive layer.
[9] The method for producing a laminate according to the above [7] or [8], further including:
   a step (III') of removing a part of the pressure-sensitive adhesive layer in the laminate 4 and patterning the pressure-sensitive adhesive layer.
[10] The method for producing a laminate according to the above [8], in which the step (III) includes a step (III-A) of performing dry-etching or wet-etching on the pressure-sensitive adhesive layer in the laminate 3 or the laminate 4 by using the semiconductor layer 1 or the protective layer 1 in the laminate 3 as a mask.
[11] The method for producing a laminate according to the above [9], in which the step (III') includes a step (III'-A) of performing dry-etching or wet-etching on the pressure-sensitive adhesive layer in the laminate 4 by using the semiconductor layer 1, the protective layer 1, or the laser-absorbing temporary adhesive layer 1 in the laminate 4 as a mask.
[12] The method for producing a laminate according to any one of the above [6] to [11], further including:
   a step (IV) of removing the protective layer 1 from the laminate 3.
[13] The method for producing a laminate according to any one of the above [7] to [12], further including:
   a step (IV') of removing the laser-absorbing temporary adhesive layer 1 and the the protective layer 1 from the laminate 4.
[14] A method for producing a semiconductor device, including:
   a step (V) of causing a surface of the laminate obtained by the method for producing a laminate according to the above [12] or [13] on the semiconductor layer 1 side to face a surface of a circuit substrate on which a circuit is formed, and bonding the semiconductor layer 1 in the laminate to the circuit substrate by thermocompression-bonding.
[15] The method for producing a semiconductor device according to the above [14], further including:
   after the step (V), a step (VI) of removing a pressure-sensitive adhesive layer-attached support substrate 2 from a structure in which the semiconductor layer 1 in the laminate is bonded to the circuit substrate.
[16] The method for producing a semiconductor device according to the above [14] or [15], in which the semiconductor device is a silicon photonic semiconductor device.
[17] A laminate including:
   a support substrate 2, a pressure-sensitive adhesive layer, a semiconductor layer 1, and a protective layer 1 laminated in this order, in which
   the pressure-sensitive adhesive layer has a patterned shape.

### [Examples]

Hereinafter, the present invention will be described with reference to Examples, but the present invention is not limited to these Examples.

### (1) Preparation of Laminate α and Laminate β in Laminate 1

Varnish a prepared by the method to be described later was applied to a 4-inch quartz substrate having an alignment mark and having a thickness of 0.5 mm by using a spinner, followed by pre-baking on a hot plate at 120°C for 3 minutes, and then heating and curing at 225°C for 5 minutes, to prepare a laminate α-1 in which the laser-absorbing temporary adhesive layer 1 was laminated on the quartz substrate (laser-transmitting substrate 1).

In addition, Varnish b prepared by the method to be described later was applied to another quartz substrate by using a spinner, followed by pre-baking on a hot plate at 120°C for 3 minutes and heating and curing at 250°C for 30 minutes, to laminate the laser-absorbing layer 1 on the quartz substrate. Further, Varnish c prepared by the method to be described later was applied to the laser-absorbing layer 1 by using a spinner, followed by pre-baking on a hot plate at 120°C for 3 minutes, and subsequent heating and curing at 225°C for 5 minutes, to prepare a laminate β-1 in which the laser-absorbing layer 1 and the temporary adhesive layer 2 were laminated in this order on the quartz substrate (laser-transmitting substrate 1).

### The thicknesses of the laser-absorbing temporary adhesive layer 1 in the laminate α-1 and the laser-absorbing layer 1 and the temporary adhesive layer 2 in the laminate β-1 were measured by cleaving each laminate and observing the cross section by using a scanning electron microscope (S-4800, manufactured by Hitachi High-Tech Corporation).

Further, laminates α-2 to α-6 in which the kind of the varnish and the thickness were changed from those in the laminate α-1 and laminates β-2 to β-11 in which the kind of the varnish and the thickness were changed from those in the laminate β-1 were formed. The compositions and the measurement results of the thickness are summarized in Tables 1 and 2.

**[Table 1]**

| | Substrate | Varnish name | Thickness (µm) | Absorbance of laser-absorbing temporary adhesive layer 1 per 1 µm of thickness | | |
|---|---|---|---|---|---|---|
| | | | | 248 nm | 266 nm | 355 nm |
| Laminate α-1 | Quartz | Varnish a | 5 | 2.4 | 3.9 | 0.6 |
| Laminate α-2 | Quartz | Varnish f | 0.8 | 2.2 | 2.8 | 0.6 |
| Laminate α-3 | Quartz | Varnish f | 2.5 | 2.2 | 2.8 | 0.6 |
| Laminate α-4 | Quartz | Varnish f | 5 | 2.2 | 2.8 | 0.6 |
| Laminate α-5 | Quartz | Varnish f | 11 | 2.2 | 2.8 | 0.6 |
| Laminate α-6 | Quartz | Varnish f | 16 | 2.2 | 2.8 | 0.6 |

**[Table 2]**

| | Substrate | Laser-absorbing temporary adhesive layer 1 | | | | Absorbance of laser-absorbing layer 1 per 1 µm of thickness | | |
|---|---|---|---|---|---|---|---|---|
| | | Laser-absorbing layer 1 | | Temporary adhesive layer 2 | | | | |
| | | Varnish | Thickness (µm) | Varnish | Thickness (µm) | 248 nm | 266 nm | 355 nm |
| Laminate β-1 | Quartz | Varnish b | 3 | Varnish c | 2 | 4.5 | 4.8 | 1.9 |
| Laminate β-2 | Quartz | Varnish b | 2 | Varnish e | 3 | 4.5 | 4.8 | 1.9 |
| Laminate β-3 | Quartz | Varnish b | 2 | Varnish g | 3 | 4.5 | 4.8 | 1.9 |
| Laminate β-4 | Quartz | Varnish b | 2 | Varnish e | 0.08 | 4.5 | 4.8 | 1.9 |
| Laminate β-5 | Quartz | Varnish b | 2 | Varnish e | 0.25 | 4.5 | 4.8 | 1.9 |
| Laminate β-6 | Quartz | Varnish b | 2 | Varnish e | 5.5 | 4.5 | 4.8 | 1.9 |
| Laminate β-7 | Quartz | Varnish b | 2 | Varnish e | 11 | 4.5 | 4.8 | 1.9 |
| Laminate β-8 | Quartz | Varnish b | 0.05 | Varnish e | 3 | 4.5 | 4.8 | 1.9 |
| Laminate β-9 | Quartz | Varnish b | 0.25 | Varnish e | 3 | 4.5 | 4.8 | 1.9 |
| Laminate β-10 | Quartz | Varnish b | 3.5 | Varnish e | 3 | 4.5 | 4.8 | 1.9 |
| Laminate β-11 | Quartz | Varnish b | 6 | Varnish e | 3 | 4.5 | 4.8 | 1.9 |

### (2)-1 Preparation of Laminate 1 from Laminate 0 Having Tether Structure

Separately, a sacrificial layer was formed on an InP substrate, and an epitaxially grown crystal film of InGaAsP (thickness: 0.5 µm, MQW (= multiple quantum well structure)) (hereinafter also referred to as MQW) was formed as the semiconductor layer 1 on the sacrificial layer, according to a known technique described in Non Patent Literature 2 (Jing Zhang et al., III-V-on-Si photonic integrated circuits realized using micro-transfer-printing, APL Photon., 2019, 4, 110803) or the like. As the protective layer 1, a SiO₂ film of 0.3 µm was formed thereon by using a CVD technique, and then the SiO₂-attached MQW was separated into small pieces (size: 50 µm × 400 µm). The distance between the small pieces was set to 200 µm. Thereafter, a photoresist was formed so as to cover the small pieces, and the sacrificial layer was removed, thereby forming a laminate 0-1 having a bridge structure in which the InP substrate and the epitaxially grown crystal film were connected by the photoresist as a Tether. That is, as illustrated in FIG. 7A, the above-described bridge structure has a structure in which a space at which the sacrificial layer has existed, that is, the hollow (reference numeral 55), is present on the InP substrate, that is, the semiconductor wafer (reference numeral 51), and the semiconductor layer 1 (reference numeral 14) (epitaxially grown crystal film) and the protective layer 1 (reference numeral 13) laminated thereon are supported from a side surface by the photoresist layer (reference numeral 54), and a small piece including the semiconductor layer 1 (reference numeral 14) and the protective layer 1 (reference numeral 13) has an upper surface and a side surface covered with the photoresist layer (reference numeral 54). At this time, the thickness of the photoresist on the upper surface of a MQW layer was set to 2 µm. Thereafter, the bridge structure was cut together with the InP substrate, and the laminate 0-1 in which 100 small pieces of the SiO₂-attached MQW were mounted on the InP substrate was prepared.

Unlike in the preparation of the laminate 0-1, the thickness of the MQW was set to 2.0 µm, and a Tether structure was formed by forming the photoresist layer without forming a SiO₂ layer. Thereafter, the photoresist on the upper surface of the MQW was removed by dry-etching, so that the photoresist layer was formed only on the side surfaces of the sacrificial layer and the semiconductor layer 1 (MQW) and the photoresist did not remain on the MQW. Thereafter, the sacrificial layer was removed and the substrate was cut to obtain 100 small pieces of MQW on the InP substrate. Accordingly, a laminate 0-3 having no protective layer 1 on the upper surface of the MQW was prepared.

A laminate 0-4 having only a photoresist of 2 µm as the protective layer 1 was prepared in the same manner as the laminate 0-1 except that the inorganic protective layer 1 (SiO₂) was not formed, unlike in the preparation of the laminate 0-1.

Unlike in the preparation of the laminate 0-1, a SiN layer of 0.08 µm was formed instead of the SiO₂ layer. Subsequently, the photoresist layer was formed, and then the photoresist layer on the SiN layer was removed by dry-etching, so that the photoresist layer was formed only on side surfaces of an insulating layer, the semiconductor layer 1 (MQW), and the protective layer 1 (SiN), and the photoresist did not remain on SiN. Thereafter, the sacrificial layer was removed and the substrate was cut to obtain 100 small pieces of SiN-attached MQW on the InP substrate. Accordingly, a laminate 0-5 having SiN of 0.08 µm as the protective layer 1 on the upper surface of the MQW was prepared.

Unlike in the preparation of the laminate 0-5, the kind and the thickness of the protective layer 1 were changed according to Table 3 below to prepare laminates 0-6 to 0-8. The configurations of the prepared laminates 0 are summarized in Table 3.

**[Table 3]**

| Kind of laminate 0 | Structure | Substrate | Semiconductor layer 1 | Protective layer 1 | |
|---|---|---|---|---|---|
| | | Kind | Kind Thickness (µm) | Kind Thickness (µm) | |
| Laminate 0-1 | Bridge structure | InP | InGaAsP 0.5 | Photoresist 2.0 | SiO₂ 0.3 |
| Laminate 0'-2 | Laminated structure | Dicing tape | GaAs and AlGaS Total: 0.5 | - | SiO₂ 0.1 |
| Laminate 0-3 | Bridge structure | InP | InGaAsP 2.0 | - | - |
| Laminate 0-4 | Bridge structure | InP | InGaAsP 0.5 | Photoresist 2.0 | - |
| Laminate 0-5 | Bridge structure | InP | InGaAsP 0.5 | - | SiN 0.08 |
| Laminate 0-6 | Bridge structure | InP | InGaAsP 0.5 | - | SiN 0.15 |
| Laminate 0-7 | Bridge structure | InP | InGaAsP 0.5 | - | SiN 0.35 |
| Laminate 0-8 | Bridge structure | InP | InGaAsP 0.5 | - | SiO₂ 0.4 |

The laminate 0-1 was superposed on the temporary adhesive layer 2 side of the laminate β-1 in a state where the photoresist side of the laminate 0-1 on the protective layer 1 faced thereto, and then pressure-bonding and temporary adhesion were performed by using a vacuum laminator. Thereafter, the InP substrate in the laminate 0-1 was peeled off, to prepare a laminate 1-1 in which the quartz substrate, the laser-absorbing layer 1, the temporary adhesive layer 2, the photoresist, the protective layer 1 (SiO₂), and the semiconductor layer 1 (MQW) were laminated in this order. The MQW on the laminate 1-1 was observed by using an optical microscope, and the number of small pieces of the semiconductor layer 1 (MQW) laminated on the temporary adhesive layer 2 and the presence or absence of cracks in each chip were checked. That is, the number of small pieces of the semiconductor layer 1 (MQW) is the number thereof on the 4-inch quartz substrate.

Further, in each combination of the laminate 0-1, the laminates 0-3 to 0-6, and the laminates α-1 to α-6 and β-1 to β-11, the semiconductor layer 1 was subjected to temporary adhesion in the same method to prepare laminates 1-3 to 1-25. The combination of the laminates and the temporary adhesion result of the semiconductor layer 1 are summarized in Tables 4 and 5.

**[Table 4]**

| Kind of laminate 1 | Kind of laminate α or β | Kind of laminate 0 | Result of laminating semiconductor layer 1 on laminate α or β | | Adhesive strength (N/cm) of interface between laser-absorbing temporary adhesive layer 1 or temporary adhesive layer 2 and photoresist or protective layer 1 |
|---|---|---|---|---|---|
| | | | Number of laminated semiconduct or layers 1 | Number of semiconductor layers 1 that can be laminated without cracks or chips on left | |
| Laminate 1-1 | Laminate β-1 | Laminate 0-1 | 98 | 98 | 0.12 |
| Laminate 1-2 | Laminate α-1 | Laminate 0'-2 | 95 | 98 | 0.14 |
| Laminate 1-3 | Laminate α-1 | Laminate 0-1 | 98 | 96 | 0.14 |
| Laminate 1-4 | Laminate α-2 | Laminate 0-1 | 80 | 65 | 0.01 |
| Laminate 1-5 | Laminate α-3 | Laminate 0-1 | 87 | 80 | 0.08 |
| Laminate 1-6 | Laminate α-4 | Laminate 0-1 | 99 | 98 | 0.1 |
| Laminate 1-7 | Laminate α-5 | Laminate 0-1 | 99 | 97 | 0.13 |
| Laminate 1-8 | Laminate α-6 | Laminate 0-1 | 100 | 98 | 0.22 |
| Laminate 1-9 | Laminate β-2 | Laminate 0-1 | 97 | 94 | 0.07 |
| Laminate 1-10 | Laminate β-3 | Laminate 0-1 | 99 | 96 | 0.1 |
| Laminate 1-11 | Laminate β-4 | Laminate 0-1 | 73 | 53 | 0.02 |
| Laminate 1-12 | Laminate β-5 | Laminate 0-1 | 85 | 73 | 0.03 |

**[Table 5]**

| Kind of laminate 1 | Kind of laminate α or β | Kind of laminate 0 | Result of laminating semiconductor layer 1 on laminate α or β | | Adhesive strength (N/cm) of interface between laser-absorbing temporary adhesive layer 1 or temporary adhesive layer 2 and photoresist or protective layer 1 |
|---|---|---|---|---|---|
| | | | Number of laminated semiconduct or layers 1 | Number of semiconductor layers 1 that can be laminated without cracks or chips on left | |
| Laminate 1-13 | Laminate β-6 | Laminate 0-1 | 97 | 95 | 0.07 |
| Laminate 1-14 | Laminate β-7 | Laminate 0-1 | 96 | 93 | 0.11 |
| Laminate 1-15 | Laminate β-8 | Laminate 0-1 | 97 | 94 | 0.07 |
| Laminate 1-16 | Laminate β-9 | Laminate 0-1 | 97 | 94 | 0.07 |
| Laminate 1-17 | Laminate β-10 | Laminate 0-1 | 97 | 94 | 0.07 |
| Laminate 1-18 | Laminate β-11 | Laminate 0-1 | 97 | 94 | 0.07 |
| Laminate 1-19 | Laminate β-2 | Laminate 0-3 | 94 | 19 | 0.12 |
| Laminate 1-20 | Laminate β-2 | Laminate 0-4 | 96 | 83 | 0.12 |
| Laminate 1-21 | Laminate β-2 | Laminate 0-5 | 95 | 51 | 0.12 |
| Laminate 1-22 | Laminate β-2 | Laminate 0-6 | 95 | 69 | 0.12 |
| Laminate 1-23 | Laminate β-2 | Laminate 0-7 | 96 | 86 | 0.12 |
| Laminate 1-24 | Laminate β-2 | Laminate 0-8 | 97 | 87 | 0.12 |

### (2)-2 Preparation of Laminate 1 by Using Laminate 0' Prepared by Using Dicing Tape

Epitaxially grown crystal films of GaAs and AlGaS (thickness: 0.5 µm in total) for use in a HEMT (high electron mobility transistor) for a high frequency device were formed as the semiconductor layer 1 on a GaAs substrate (thickness: 150 µm) on a dicing tape, and as the protective layer 1, SiO₂ of 0.1 µm was formed thereon. Dicing was performed on the dicing tape to form chips (size: 1.1 mm × 1.1 mm), to prepare a laminate 0'-2 in which 100 small pieces of the HEMT were placed on the dicing tape.

The configuration of the laminate 0'-2 is summarized in Table 3 described above.

The surface of SiO₂ in the laminate 0'-2 and the surface of the laser-absorbing temporary adhesive layer 1 in the laminate α-1 were bonded to each other by using a vacuum laminator. Thereafter, the surface of the dicing tape was irradiated with UV light to reduce the pressure-sensitive adhesive property of the surface of the dicing tape in contact with the GaAs substrate, and the dicing tape was removed from the laminate (reverse mounting method), to prepare a laminate 1-2 in which the quartz substrate, the laser-absorbing temporary adhesive layer 1, the protective layer 1 (SiO₂), the semiconductor layer 1 (HEMT), and the GaAs substrate were laminated in this order on the laser-absorbing temporary adhesive layer 1 side of the laminate α-1. The semiconductor layer 1 on the laminate 1-2 was visually observed from the quartz substrate side by using an optical microscope, and the number of small pieces of the semiconductor layer 1 (MQW) laminated on the temporary adhesive layer 2 and the presence or absence of cracks in each chip were checked. That is, the number of small pieces of the semiconductor layer 1 (MQW) is the number thereof on the 4-inch quartz substrate. The configuration and evaluation results of the laminate 1-2 are summarized in Table 4 described above.

### (3) Measurement of Absorbance of Laser-Absorbing Temporary Adhesive Layer 1 and Laser-Absorbing Layer 1

Varnishes a and f used for the laminates α-1 to α-6 were applied to a quartz substrate in the same manner as in (1) described above, followed by pre-baking and heating and curing, to prepare a laser-absorbing temporary adhesive layer 1-attached quartz substrate for absorbance measurement. In addition, Varnish b used for the laser-absorbing layer 1 in the preparation of the laminates β-1 to β-11 in (1) was similarly formed into a film, followed by pre-baking and heating and curing, to prepare a laser-absorbing layer 1-attached quartz substrate for absorbance measurement. The thickness was also measured in the same manner as in (1) described above.

For the laser-absorbing temporary adhesive layer 1-attached quartz substrate and the laser-absorbing layer 1-attached quartz substrate for absorbance measurement obtained as described above, the absorbance from 200 nm to 400 nm was continuously measured by using an ultraviolet-visible spectrophotometer (U-2910, manufactured by Hitachi, Ltd.). Among these, values at 248 nm, 266 nm, and 355 nm were read out, and the absorbance per 1 µm was calculated according to the following equation (1). The results are summarized in Tables 1 and 2 described above.

Absorbance per 1 µm = actually measured absorbance/measured thickness (µm) Equation (1)

### (4) Measurement of Adhesive Strength on Contact Surface between Laser-Absorbing Temporary Adhesive Layer 1 or Temporary Adhesive Layer 2 and Protective Layer 1

In the laminates 1-1 and 1-3 to 1-24 prepared in the above (2)-1, a dicing tape (UDT-1025MC) was attached to the surface of the semiconductor layer 1 and peeled off, to peel off the protective layer 1-attached semiconductor layer 1 and the photoresist from the temporary adhesive layer 2. Similarly, in the laminate 1-2 prepared in the above (2)-2, the protective layer 1-attached semiconductor layer 1 was peeled off from the laser-absorbing temporary adhesive layer 1.

A polyimide film, Kapton (registered trademark) 100EN (registered trademark) (manufactured by DU PONT-TORAY CO., LTD.) cut into a strip shape of 1 cm × 9 cm was pressure-bonded to the surface of the temporary adhesive layer 2 and the laser-absorbing temporary adhesive layer 1, from which the protective layer 1-attached semiconductor layer 1 had been peeled off, at 0.1 MPa at 25°C by using a vacuum laminator. The sample was set in a tensile tester (FGS-VC, manufactured by NIDEC-SHINPO CORPORATION), and the pressure-bonded Kapton film was peeled off in a vertical direction at a constant speed of 2 mm/sec. The peel strength at this time was measured by using a digital force gauge (FGJN-5, manufactured by NIDEC-SHINPO CORPORATION). The measurement was performed three times by changing the sample, and an average value was taken as the adhesive strength.

The results of the adhesive strength measured in each laminate 1 are summarized in Tables 4 and 5 described above.

### (6) Laser Transfer (LLO) Test of Semiconductor Layer 1

### (6)-1 Preparation of Laminate 2

Varnish d for the pressure-sensitive adhesive layer to be described later was applied to a 4-inch quartz substrate having an alignment mark and having a thickness of 0.5 mm, used as the support substrate 2, by using a spinner, followed by pre-baking on a hot plate at 120°C for 3 minutes, and then heating and curing at 225°C for 10 minutes, to form a pressure-sensitive adhesive layer of about 5 µm on the quartz substrate, to thereby prepare a pressure-sensitive adhesive layer-attached support substrate 2 (laminate 2-1).

The thickness of the pressure-sensitive adhesive layer after thermal curing was measured by using an optical thickness meter (Lambda Ace, manufactured by SCREEN Holdings Co., Ltd., refractive index = 1.543).

Laminates 2-2 to 2-11 were formed in the same manner as described above by changing the varnish used for the pressure-sensitive adhesive layer and the thickness. The configuration of the laminate 2 is summarized in Table 6.

**[Table 6]**

| Kind of laminate 2 | Support substrate 2 | Laser-absorbing layer 2 | | Pressure- sensitive adhesive layer | | Elastic modulus of pressure-sensitive adhesive layer at 200°C |
|---|---|---|---|---|---|---|
| | | Varnish | Thickness (µm) | Varnish | Thickness (µm) | MPa |
| Laminate 2-1 | Quartz substrate | - | - | Varnish d | 5 | 2.05 |
| Laminate 2-2 | Quartz substrate | - | - | Varnish e | 0.8 | 0.4 |
| Laminate 2-3 | Quartz substrate | - | - | Varnish e | 1.5 | 0.4 |
| Laminate 2-4 | Quartz substrate | - | - | Varnish e | 3 | 0.4 |
| Laminate 2-5 | Quartz substrate | - | - | Varnish e | 32 | 0.4 |
| Laminate 2-6 | Quartz substrate | - | - | Varnish e | 28 | 0.4 |
| Laminate 2-7 | Quartz substrate | - | - | Varnish e | 12 | 0.4 |
| Laminate 2-8 | Quartz substrate | - | - | Varnish e | 8 | 0.4 |
| Laminate 2-9 | Quartz substrate | - | - | Varnish g | 3 | 0.5 |
| Laminate 2-10 | Quartz substrate | - | - | Varnish f | 5 | 0.3 |
| Laminate 2-11 | Quartz substrate | Varnish b | 2 | Varnish e | 3 | 0.4 |

### (6)-2 Production of Laminate 4 by Laser Transfer of Protective Layer 1-attached Semiconductor Layer 1 (Application of Laminate 1-1)

Subsequently, a laser light source, and the laminate 1-1 and the laminate 2-1 prepared by the above methods were disposed in this order. At this time, the surface of the laminate 1-1 on which the semiconductor layer 1 was held and the surface of the laminate 2-1 on which the pressure-sensitive adhesive layer was formed were held to face each other such that the interval between the surface of the semiconductor layer 1 and the surface of the pressure-sensitive adhesive layer was 50 µm. The laminate 1-1 and the laminate 2-1 were aligned to each other by using the respective alignment marks. The spot size of the laser was set to a square shape of 90 µm × 440 µm, and positions of the laser light source and the laminate 1-1 were adjusted such that one MQW small piece was disposed at a center of the spot of the laser and the adjacent semiconductor layer 1 was not irradiated with the laser.

The MQW disposed at the laser irradiation position was irradiated with a laser having a wavelength of 355 nm at an energy irradiation amount of 100 mJ/cm² to prepare a laminate 4-1 in which the support substrate 2, the pressure-sensitive adhesive layer, the semiconductor layer 1 (MQW), the protective layer 1 (SiO₂), the photoresist, the temporary adhesive layer 2, and the laser-absorbing layer 1 were laminated in this order. Ten samples were subjected to LLO of the semiconductor layer 1, and then observed by using an optical microscope to check the presence or absence of cracks and damages in the MQW and SiO₂ layers. The positions of the small pieces of the semiconductor layer 1 before and after the transfer were calculated based on the alignment marks and compared with the positions in the laminate 1. Those having a deviation of less than ±2 µm in both a short axis direction and a long axis direction of the MQW chip were evaluated as A, those having a deviation of ±2 µm or more and ±5 µm or less were evaluated as B, those having a deviation of more than ±5 µm were evaluated as C, those in which the transfer was not possible were evaluated as D, and those in which the transfer was possible but cracks or chips occurred were evaluated as E. The number of each evaluation result is summarized in Table 7.

### (6)-3 Production of Laminate 3 by Transfer of Protective Layer 1-attached Semiconductor Layer 1 (Application of Laminate 1-2)

A laminate 3-2 in which the support substrate 2, the pressure-sensitive adhesive layer, GaAs, the semiconductor layer 1 (HEMT), the protective layer 1 (SiO₂), and the laser-absorbing temporary adhesive layer 1 were laminated in this order was prepared in the same manner as in the above (6)-2 except that the laminate 1-2 was used instead of the laminate 1-1. During observation using an optical microscope, no debris and adhesive residues derived from the laser-absorbing temporary adhesive layer 1 were observed on the surface of the pressure-sensitive adhesive layer above and around the transferred GaAs, HEMT, and SiO₂. The evaluation methods of the presence or absence of damages of the transferred HEMT and the positional accuracy are the same as in (6)-2. The evaluation results are summarized in Table 7.

**[Table 7]**

| Ex. No. | Kind of laminate 3 or 4 | Kind of laminate 1 | Kind of laminate 2 | Evaluation result of transferred semiconductor layer 1 | | | | |
|---|---|---|---|---|---|---|---|---|
| | | | | Evaluation A | Evaluation B | Evaluation C | Evaluation D | Evaluation E |
| Ex. 1 | Laminate 4-1 | Laminate 1-1 | Laminate 2-1 | 2 | 1 | 5 | 0 | 2 |
| Ex. 2 | Laminate 3-2 | Laminate 1-2 | Laminate 2-1 | 4 | 1 | 0 | 5 | 0 |
| Ex. 3 | Laminate 4-3 | Laminate 1-3 | Laminate 2-4 | 4 | 3 | 2 | 0 | 1 |
| Ex. 4 | Laminate 4-4 | Laminate 1-4 | Laminate 2-4 | 4 | 0 | 0 | 0 | 6 |
| Ex. 5 | Laminate 4-5 | Laminate 1-5 | Laminate 2-4 | 7 | 0 | 0 | 0 | 3 |
| Ex. 6 | Laminate 4-6 | Laminate 1-6 | Laminate 2-4 | 6 | 1 | 0 | 2 | 1 |
| Ex. 7 | Laminate 4-7 | Laminate 1-7 | Laminate 2-4 | 4 | 2 | 0 | 4 | 0 |
| Ex. 8 | Laminate 4-8 | Laminate 1-8 | Laminate 2-4 | 0 | 0 | 3 | 7 | 0 |
| Ex. 9 | Laminate 4-9 | Laminate 1-9 | Laminate 2-4 | 9 | 1 | 0 | 0 | 0 |
| Ex. 10 | Laminate 4-10 | Laminate 1-10 | Laminate 2-4 | 7 | 2 | 1 | 0 | 0 |
| Ex. 11 | Laminate 4-11 | Laminate 1-11 | Laminate 2-4 | 4 | 1 | 0 | 0 | 5 |
| Ex. 12 | Laminate 4-12 | Laminate 1-12 | Laminate 2-4 | 5 | 2 | 0 | 0 | 3 |
| Ex. 13 | Laminate 4-13 | Laminate 1-13 | Laminate 2-4 | 3 | 2 | 3 | 1 | 1 |
| Ex. 14 | Laminate 4-14 | Laminate 1-14 | Laminate 2-4 | 1 | 4 | 2 | 3 | 0 |
| Ex. 15 | Laminate 4-15 | Laminate 1-15 | Laminate 2-4 | 1 | 4 | 1 | 4 | 0 |
| Ex. 16 | Laminate 4-16 | Laminate 1-16 | Laminate 2-4 | 2 | 5 | 1 | 2 | 0 |
| Ex. 17 | Laminate 4-17 | Laminate 1-17 | Laminate 2-4 | 3 | 3 | 1 | 3 | 0 |
| Ex. 18 | Laminate 4-18 | Laminate 1-18 | Laminate 2-4 | 0 | 0 | 3 | 7 | 0 |
| Ex. 19 | Laminate 4-20 | Laminate 1-20 | Laminate 2-4 | 4 | 2 | 0 | 0 | 4 |
| Ex. 20 | Laminate 4-21 | Laminate 1-21 | Laminate 2-4 | 2 | 1 | 0 | 0 | 7 |
| Ex. 21 | Laminate 4-22 | Laminate 1-22 | Laminate 2-4 | 3 | 2 | 0 | 0 | 5 |
| Ex. 22 | Laminate 4-23 | Laminate 1-23 | Laminate 2-4 | 4 | 4 | 0 | 0 | 2 |
| Ex. 23 | Laminate 4-24 | Laminate 1-24 | Laminate 2-4 | 4 | 4 | 0 | 0 | 2 |
| Ex. 24 | Laminate 4-25 | Laminate 1-9 | Laminate 2-2 | 2 | 1 | 4 | 0 | 3 |
| Ex. 25 | Laminate 4-26 | Laminate 1-9 | Laminate 2-3 | 3 | 2 | 3 | 0 | 2 |
| Ex. 26 | Laminate 4-27 | Laminate 1-9 | Laminate 2-5 | 9 | 1 | 0 | 0 | 0 |
| Ex. 27 | Laminate 4-28 | Laminate 1-9 | Laminate 2-6 | 9 | 1 | 0 | 0 | 0 |
| Ex. 28 | Laminate 4-29 | Laminate 1-9 | Laminate 2-7 | 9 | 1 | 0 | 0 | 0 |
| Ex. 29 | Laminate 4-30 | Laminate 1-9 | Laminate 2-8 | 9 | 1 | 0 | 0 | 0 |
| Ex. 30 | Laminate 4-31 | Laminate 1-9 | Laminate 2-9 | 8 | 2 | 0 | 0 | 0 |
| Ex. 31 | Laminate 4-32 | Laminate 1-9 | Laminate 2-10 | 9 | 1 | 0 | 0 | 0 |
| Ex. 32 | Laminate 4-33 | Laminate 1-9 | Laminate 2-11 | 9 | 1 | 0 | 0 | 0 |
| Comp. Ex. 1 | Laminate 4-19 | Laminate 1-19 | Laminate 2-4 | 0 | 0 | 0 | 0 | 10 |

### (7)-1 Dry-Etching on Pressure-Sensitive Adhesive Layer

The laminate 4-1 prepared in (6)-2 was treated by dry-etching under the following conditions by using a high throughput ashing and etching device (MAS-8220AT, manufactured by Canon Marketing Japan Inc.), and the temporary adhesive layer 2, the laser-absorbing layer 1, the photoresist, and the pressure-sensitive adhesive layer in a region other than the protective layer 1 (SiO₂) were removed by using the protective layer 1 (SiO₂) as a mask. The removal of the pressure-sensitive adhesive layer, and the temporary adhesive layer 2, the laser-absorbing layer 1, and the photoresist thereon was confirmed by checking, by using a microscopic IR spectrophotometer, the disappearance of the peaks of the temporary adhesive layer 2, the laser-absorbing layer 1, the photoresist, and the pressure-sensitive adhesive layer.

Similarly, in the laminate 3-2 prepared in (6)-3, the protective layer 1 (SiO₂) was used as a mask and the laser-absorbing temporary adhesive layer 1 and the pressure-sensitive adhesive layer in a region other than the protective layer 1 (SiO₂) were removed. The removal of the pressure-sensitive adhesive layer was confirmed by checking, by using a microscopic IR spectrophotometer, the disappearance of the peaks of the laser-absorbing temporary adhesive layer 1 and the pressure-sensitive adhesive layer.

### Dry-etching conditions:

Etching gas: CF₄/O₂ = 80/20 (volume ratio)
RF power: 300 W
Etching temperature: 100°C
Treatment pressure: 20 Pa
Gas flow rate: 50 sccm

### (7)-2 Wet-Etching on Pressure-Sensitive Adhesive Layer

The laminate 4-1 prepared in (6)-2 was immersed in CHN at room temperature. After the immersion, the surface was washed with acetone and pure water in this order and dried on a hot plate at 150°C for 5 minutes. The removal of the laser-absorbing temporary adhesive layer 1 laminated on the protective layer 1 was confirmed. In addition, the thickness of the pressure-sensitive adhesive layer at a portion where the semiconductor layer 1 was not laminated was measured by using an optical thickness meter (Lambda Ace, manufactured by SCREEN Holdings Co., Ltd., refractive index = 1.543), and the etched amount was calculated by comparing with the thickness before the treatment. The results are summarized in Table 8.

### (8)-1 Transfer by Thermocompression-Bonding to Circuit Substrate

By using the laminate 4-1 or the laminate 3-2 including the patterned pressure-sensitive adhesive layer prepared in (7), thermal transfer was performed on a photonic integrated circuit using an SOI substrate described in JP2017-500735A or on a Si circuit substrate for a power amplifier. Immediately before the thermal transfer, the SiO₂ surface of the laminate 4-1 or the laminate 3-2 having the patterned pressure-sensitive adhesive layer, a photonic integrated circuit surface, and a Si circuit surface were subjected to a treatment for 5 minutes in a UV-O₃ treatment machine to sufficiently hydrophilize the contact interface, and thermocompression-bonding was performed at 150°C and 1 MPa by using a flip chip bonder (FC-3000 (manufactured by TORAY ENGINEERING Co., Ltd.)). This is called a bonded substrate. The details of each laminate are summarized in Table 8.

**[Table 8]**

| Example | Kind of laminate 3 or 4 | Method for patterning pressure-sensitive adhesive layer | Etching ratio of pressure-sensitive adhesive layer | Bonded substrate |
|---|---|---|---|---|
| Example 33 | Laminate 4-1 | Dry etching | 100% | Photonic integrated circuit |
| Example 34 | Laminate 3-2 | Dry etching | 100% | Si circuit substrate |
| Example 35 | Laminate 4-9 | Dry etching | 100% | Photonic integrated circuit |
| Example 36 | Laminate 4-25 | Dry etching | 100% | Photonic integrated circuit |
| Example 37 | Laminate 4-26 | Dry etching | 100% | Photonic integrated circuit |
| Example 38 | Laminate 4-27 | Dry etching | 100% | Photonic integrated circuit |
| Example 39 | Laminate 4-28 | Dry etching | 100% | Photonic integrated circuit |
| Example 40 | Laminate 4-29 | Dry etching | 100% | Photonic integrated circuit |
| Example 41 | Laminate 4-30 | Dry etching | 100% | Photonic integrated circuit |
| Example 42 | Laminate 4-31 | Dry etching | 100% | Photonic integrated circuit |
| Example 43 | Laminate 4-32 | Dry etching | 100% | Photonic integrated circuit |
| Example 44 | Laminate 4-33 | Dry etching | 100% | Photonic integrated circuit |
| Example 45 | Laminate 4-9 | Wet etching | 100% | Photonic integrated circuit |
| Example 46 | Laminate 4-9 | Wet etching | 50% | Photonic integrated circuit |
| Example 47 | Laminate 4-9 | No etching | 0% | Photonic integrated circuit |

**[Table 8 (Continued)]**

| Example | Peeling off of support substrate 2 | Evaluation result of semiconductor layer 1 bonded to circuit substrate | | | |
|---|---|---|---|---|---|
| | | Evaluation A | Evaluation B | Evaluation C | Evaluation E |
| Example 33 | Mechanical peeling | 2 | 1 | 5 | 2 |
| Example 34 | Mechanical peeling | 4 | 1 | 0 | 0 |
| Example 35 | Mechanical peeling | 10 | 0 | 0 | 0 |
| Example 36 | Mechanical peeling | 8 | 0 | 0 | 2 |
| Example 37 | Mechanical peeling | 9 | 1 | 0 | 0 |
| Example 38 | Mechanical peeling | 1 | 4 | 1 | 4 |
| Example 39 | Mechanical peeling | 2 | 5 | 0 | 3 |
| Example 40 | Mechanical peeling | 4 | 4 | 0 | 2 |
| Example 41 | Mechanical peeling | 6 | 4 | 0 | 0 |
| Example 42 | Mechanical peeling | 10 | 0 | 0 | 0 |
| Example 43 | Laser peeling | 10 | 0 | 0 | 0 |
| Example 44 | Laser peeling | 10 | 0 | 0 | 0 |
| Example 45 | Mechanical peeling | 10 | 0 | 0 | 0 |
| Example 46 | Mechanical peeling | 9 | 0 | 0 | 1 |
| Example 47 | Solvent peeling | 9 | 0 | 0 | 1 |

### (8)-2 Peeling off of Support Substrate 2 and Pressure-Sensitive Adhesive Layer from Bonded Substrate

For the bonded substrate formed in (8)-1, mechanical-peeling was performed at an interface between the pressure-sensitive adhesive layer and the semiconductor layer 1 (mechanical-peeling). For laminates 4-32 and 4-33, the semiconductor layer 1 was subjected to laser irradiation from the support substrate 2 side at the same energy amount and spot size as in (6)-2, and the pressure-sensitive adhesive layer in contact with the semiconductor layer 1 was peeled off from the support substrate 2 (laser-peeling). In a laminate 4-9, for the bonded substrate subjected to the thermocompression-bonding without patterning the pressure-sensitive adhesive layer, the bonded substrate was immersed in cyclohexanone overnight, cyclohexane was impregnated from an end portion, whereby the pressure-sensitive adhesive layer was dissolved and the substrate was peeled off (solvent-peeling).

After the peeling, those having a deviation of less than ± 2 µm in both a short axis direction and a long axis direction of the semiconductor layer 1 as compared with that before the bonding were evaluated as A, those having a deviation of ±2 µm or more and less than ±5 µm were evaluated as B, those having a deviation of ± 5 µm or more were evaluated as C, and those in which bonding was possible but cracks or chips occurred were evaluated as E.

The results are summarized in Table 8.

### (9) Evaluation of Storage Modulus at 200°C

About 1 g of a varnish to be described later was charged into an aluminum cup, dried on a hot plate at 120°C for 30 minutes, and then subjected to a heat treatment on a hot plate at 250°C for 2 hours to obtain a cured product having a thickness of about 500 µm. Subsequently, a single film of the obtained cured product was cut into 0.5 cm × 3 cm length to form a strip-shaped sample. This sample was subjected to measurement in a temperature range of 25°C to 250°C in a tensile mode at a frequency of 1 Hz by using a dynamic viscoelasticity measurement device (DVA-200, manufactured by IT Measurement Control Co., Ltd.), and the storage modulus at 200°C was obtained from the obtained temperature-storage modulus curve.

The names of the abbreviations of acid dianhydrides, diamines, additives, and solvents shown in the following Production Examples and Preparation Examples are as follows.
PMDA: pyromellitic acid anhydride (manufactured by Daicel Corporation)
BPDA: 3,3',4,4'-biphenyltetracarboxylic acid anhydride (manufactured by Mitsubishi Chemical Group Corporation)
DIBOC: di-tert-butyl dicarbonate (manufactured by Tokyo Chemical Industry Co., Ltd.)
PA: phthalic acid anhydride (manufactured by Tokyo Chemical Industry Co., Ltd.)
PDA: p-phenylenediamine (manufactured by Tokyo Chemical Industry Co., Ltd.)
BAHF: 2,2-bis(3-amino-4-hydroxyphenyl)-1,1,1,3,3,3-hexafluoropropane (manufactured by Merck KGaA)
FDA: 9,9-bis(3-amino-4-hydroxyphenyl)fluorene (manufactured by Merck KGaA)
APPS2: α,ω-bis(3-aminopropyl)polydimethylsiloxane (number average molecular weight: 860)
APPS3: α,ω-bis(3-aminopropyl)polydimethylsiloxane (number average molecular weight: 1550)
APPS4: α,ω-bis(3-aminopropyl)polydimethylsiloxane (number average molecular weight: 3000)
NMP: 2-methyl-1-pyrrolidone (manufactured by Mitsubishi Chemical Group Corporation)
CHN: cyclohexanone (manufactured by Toyo Gosei Co., Ltd)
BDM: diethylene glycol butyl methyl ether (manufactured by TOHO Chemical Industry Co., Ltd.)
JER (registered trademark) 871: dimer acid-modified epoxy resin (manufactured by Mitsubishi Chemical Group Corporation)
PETG: pentaerythritol-based skeleton epoxy resin (manufactured by Showa Denko K.K.)
2E4MZ: 2-ethyl-4-methylimidazole (manufactured by SHIKOKU CHEMICALS CORPORATION)
100LM: crosslinking agent having a methylol group represented by the structure of the following formula (11). (Product name: Nikalac (registered trademark) MW-100LM, manufactured by SANWA CHEMICAL CO., LTD.) 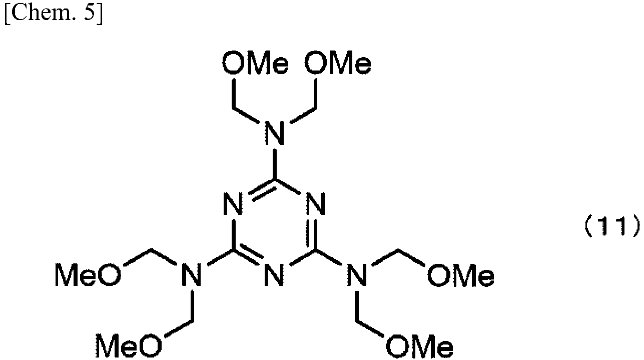
(In formula, Me represents methyl group.)
Tinuvin (registered trademark) 477, ultraviolet absorber (manufactured by BASF Japan Ltd.)
Production Example 1 (Polymerization of Resin Contained in Laser-Absorbing Layer 1)

To a reaction vessel equipped with a thermometer, a dry nitrogen inlet, a heating and cooling device using hot water and cooling water, and a stirring device, 11.82 g (109 mmol) of PDA and 195.80 g of NMP were charged and dissolved. A solution obtained by mixing 0.48 g (2.19 mmol) of DIBOC and 26.10 g of NMP was added dropwise thereto under stirring, and the mixture was stirred at 40°C for 1 hour. Next, 12.87 g (43.7 mmol) of BPDA and 13.05 g of NMP were added thereto, followed by stirring at 60°C for 30 minutes. Subsequently, 13.83 g (63 mmol) of PMDA and 13.05 g of NMP were added thereto, followed by stirring at 60°C for 4 hours, to obtain a PAA-1-containing solution containing 13 parts by weight of a polyimide precursor PAA-1 with respect to 100 parts by weight of the total volume.

### Production Example 2 (Polymerization of Resin Contained in Laser-Absorbing Temporary Adhesive Layer 1 and Temporary Adhesive Layer 2)

To a reaction vessel equipped with a thermometer, a dry nitrogen inlet, a heating and cooling device using hot water and cooling water, and a stirring device, 344.00 g (400 mmol) of APPS2, 37.50 g (25 mmol) of APPS3, and 27.47 g (75 mmol) of BAHF were charged together with 481.40 g of CHN, and dissolved, and then 14.81 g (100 mmol) of PA and 20.00 g of CHN were added thereto, followed by stirring at 60°C for 15 minutes. Subsequently, 97.61 g (450 mmol) of PMDA and 20.00 g of CHN were added thereto, and the mixture was stirred at 60°C for 1 hour, and then heated to 145°C and reacted for 4 hours to obtain a PIS-1-containing solution containing 50 parts by weight of polyimidesiloxane PIS-1 with respect to 100 parts by weight of the total volume.

### Production Example 3 (Polymerization of Resin Contained in Pressure-Sensitive Adhesive Layer)

Polymerization was performed in the same manner as in Production Example 2 except that the amount of APPS2 was 340.56 g (396 mmol), the amount of APPS3 was 44.95 g (29 mmol), the amount of BAHF was 27.47 g (75 mmol), and the amount of CHN was 482.00 g, to obtain a PIS-2-containing solution containing 50 parts by weight of polyimidesiloxane PIS-2 with respect to 100 parts by weight of the total volume.

### Production Example 4 (Polymerization of Resin Contained in Temporary Adhesive Layer 2 and Pressure-Sensitive Adhesive Layer)

To a reaction vessel equipped with a thermometer, a dry nitrogen inlet, a heating and cooling device using hot water and cooling water, and a stirring device, 620 g (400 mmol) of APPS3, 150 g (50 mmol) of APPS4, and 18.31 g (50 mmol) of BAHF were charged together with 856 g of CHN, and stirred at 60°C for 15 minutes. Subsequently, 107.97 g (495 mmol) of PMDA and 40.00 g of CHN were added thereto, and the mixture was stirred at 60°C for 1 hour, and then heated to 145°C and reacted for 4 hours to obtain a PIS-3-containing solution containing 50 parts by weight of polyimidesiloxane PIS-3 with respect to 100 parts by weight of the total volume.

### Production Example 5 (Polymerization of Resin Contained in Laser-Absorbing Layer 1 and Pressure-Sensitive Adhesive Layer)

To a reaction vessel equipped with a thermometer, a dry nitrogen inlet, a heating and cooling device using hot water and cooling water, and a stirring device, 736 g (475 mmol) of APPS3 and 9.51 g (25 mmol) of FDA were charged together with 821 g of BDM, and stirred at 60°C for 60 minutes. Subsequently, 107.97 g (495 mmol) of PMDA and 40.00 g of BDM were added thereto, and the mixture was further stirred at 60°C for 1 hour, and then heated to 145°C and reacted for 4 hours to obtain a PIS-4-containing solution containing 50 parts by weight of polyimidesiloxane PIS-4 with respect to 100 parts by weight of the total volume.

### Preparation Example 1 (Preparation of Varnish a)

To a vial bottle, 2.82 g of the PIS-1-containing solution (1.41 g of polyimidesiloxane PIS-1, 1.41 g of CHN) was charged, and 0.28 g of PETG, 0.01 g of 100LM, 0.01 g of 2E4MZ, 0.28 g of Tinuvin (registered trademark) 477, and further 6.59 g of CHN were added thereto, followed by stirring, to prepare Varnish a.

### Preparation Example 2 (Preparation of Varnish b)

To a vial bottle, 5.0 g of the PAA-1-containing solution (0.65 g of the polyimide precursor PAA-1 and 4.35 g of NMP) was charged, and 5.0 g of NMP was added thereto, followed by stirring, to prepare Varnish b.

### Preparation Example 3 (Preparation of Varnish c)

To a vial bottle, 41 g of the PIS-1-containing solution (20.5 g of polyimidesiloxane PIS-1, 20.5 g of CHN) was charged, 4 g of JER (registered trademark) 871, 0.2 g of 100LM, 0.2 g of 2E4EMZ, and 4.5 g of CHN were added thereto, followed by stirring, to prepare Varnish c.

### Preparation Example 4 (Preparation of Varnish d)

To a vial bottle, 41 g of the PIS-2-containing solution (20.5 g of polyimidesiloxane PIS-2, 20.5 g of CHN) was charged, 4 g of JER (registered trademark) 871, 0.2 g of 100LM, 0.2 g of 2E4EMZ, and 4.5 g of CHN were added thereto, followed by stirring, to prepare Varnish d.

Hereinafter, varnishes e to g were prepared according to the description in Table 9.

**[Table 9]**

| Varnish name | Resin solution | Additive | | | | Solvent | Application |
|---|---|---|---|---|---|---|---|
| | Kind Weight | Kind Weight | Kind Weight | Kind Weight | Kind Weight | Kind Weight | |
| Varnish a | PIS-1 2.82 g | PETG 0.28 g | 100LM 0.01 g | 2E4MZ 0.01 g | Tinuvin 477 0.28 g | CHN 6.59 g | Laser-absorbing layer temporary adhesive layer 1 |
| Varnish b | PAA-1 5.00 g | - | - | - | - | NMP 5.00 g | Laser-absorbing layer 1 |
| Varnish c | PIS-1 41.00 g | JER871 4.00 g | 100LM 0.20 g | 2E4MZ 0.20 g | | CHN 4.5 g | Temporary adhesive layer 2 |
| Varnish d | PIS-2 41.00 g | JER871 4.00 g | 100LM 0.20 g | 2E4MZ 0.20 g | | CHN 4.5 g | Pressure-sensitive adhesive layer |
| Varnish e | PIS-3 7.00 g | - | - | - | | CHN 3.00 g | Temporary adhesive layer 2 and pressure-sensitive adhesive layer |
| Varnish f | PIS-4 6.67 g | - | - | - | Tinuvin 477 0.67 g | BDM 2.66 g | Laser-absorbing layer temporary adhesive layer 1 and pressure-sensitive adhesive layer |
| Varnish g | PIS-4 7.00 g | - | | - | - | BDM 3.00 g | Temporary adhesive layer 2 and pressure-sensitive adhesive layer |

Varnishes a to g were all filtered through a polytetrafluoroethylene (PTFE) filter having a pore size of 0.2 µm. By using these varnishes, the laminates α and β were prepared by the methods described above.

By using the varnishes, the storage modulus at 200°C of the pressure-sensitive adhesive layer was evaluated as described in the above (9) Evaluation of Storage Modulus at 200°C. The results are shown in Table 10.

**[Table 10]**

| Varnish name | Elastic modulus at 200°C |
|---|---|
| | MPa |
| Varnish d | 2.05 |
| Varnish e | 0.4 |
| Varnish f | 0.3 |
| Varnish g | 0.5 |

Although the present invention has been described in detail with reference to specific embodiments, it is apparent to those skilled in the art that various changes and modifications can be made without departing from the spirit and scope of the present invention. Note that, the present application is based on Japanese Patent Application (No. 2023-072581) filed on April 26, 2023, and the content thereof is incorporated herein by reference. All references cited herein are incorporated as a whole.

### REFERENCE SIGNS LIST

11 laser-transmitting substrate 1
12 laser-absorbing temporary adhesive layer 1
13 protective layer 1
14 semiconductor layer 1
15 laser irradiation
16 temporary adhesive layer 2
17 laser-absorbing layer 1
21 support substrate 2
22 pressure-sensitive adhesive layer
23 laser-absorbing layer 2
24 pressure-sensitive adhesive layer present between semiconductor layer 1 and support substrate 2
25 pressure-sensitive adhesive layer on portion of support substrate 2 not having semiconductor layer 1
41 circuit substrate
51 semiconductor wafer
52 sacrificial layer
54 photoresist layer
55 hollow
100 laminate 1
101 laminate 1'
200 laminate 2
300 laminate 3
400 semiconductor device
501 laminate 0"
502 laminate α
503 laminate 0
600 laminate 4

## Claims

1. A laminate comprising:
a laser-transmitting substrate 1; and
a laser-absorbing temporary adhesive layer 1, a protective layer 1, and a semiconductor layer 1 laminated in this order on the laser-transmitting substrate 1.

2. The laminate according to claim 1, wherein the semiconductor layer 1 is a compound semiconductor.

3. The laminate according to claim 2, wherein the compound semiconductor is AlGaInAs, InGaAs, InP, InGaAsP, AlAs, InAs, GaAs, AlN, AlP, GaN, InN, or SiC.

4. The laminate according to any one of claims 1 to 3, wherein the protective layer 1 is at least one of an oxide film and a nitride film.

5. The laminate according to claim 4, wherein the protective layer 1 contains SiO₂.

6. A method for producing a laminate, successively comprising:
a step (I) of using a laminate 1, in which a laser-absorbing temporary adhesive layer 1, a protective layer 1, and a semiconductor layer 1 are laminated in this order on a laser-transmitting substrate 1, and a laminate 2, in which a pressure-sensitive adhesive layer is laminated on a support substrate 2, to cause a surface of the laminate 1 on a semiconductor layer 1 side and a surface of the laminate 2 on a pressure-sensitive adhesive layer side to face each other; and
a step (II) of irradiating the laser-absorbing temporary adhesive layer 1 with a laser from a surface side of the laminate 1 opposite to the surface thereof on the semiconductor layer 1 side while transmitting the laser through the laser-transmitting substrate 1, and transferring a structure 1 in which the protective layer 1 and the semiconductor layer 1 are laminated to the laminate 2 to form a laminate 3 in which the pressure-sensitive adhesive layer, the semiconductor layer 1, and the protective layer 1 are laminated in this order on the support substrate 2.

7. The method for producing a laminate according to claim 6, wherein
in the step (II),
the structure 1 is a structure 2 in which the laser-absorbing temporary adhesive layer 1, the protective layer 1, and the semiconductor layer 1 are laminated, and
the laminate 3 is a laminate 4 in which the pressure-sensitive adhesive layer, the semiconductor layer 1, the protective layer 1, and the laser-absorbing temporary adhesive layer 1 are laminated in this order on the support substrate 2.

8. The method for producing a laminate according to claim 6, further comprising:
a step (III) of removing a part of the pressure-sensitive adhesive layer in the laminate 3 and patterning the pressure-sensitive adhesive layer.

9. The method for producing a laminate according to claim 7, further comprising:
a step (III') of removing a part of the pressure-sensitive adhesive layer in the laminate 4 and patterning the pressure-sensitive adhesive layer.

10. The method for producing a laminate according to claim 8, wherein
the step (III) includes a step (III-A) of performing dry-etching or wet-etching on the pressure-sensitive adhesive layer in the laminate 3 by using the semiconductor layer 1 or the protective layer 1 in the laminate 3 as a mask.

11. The method for producing a laminate according to claim 9, wherein
the step (III') includes a step (III'-A) of performing dry-etching or wet-etching on the pressure-sensitive adhesive layer in the laminate 4 by using the semiconductor layer 1, the protective layer 1, or the laser-absorbing temporary adhesive layer 1 in the laminate 4 as a mask.

12. The method for producing a laminate according to claim 6, 8, or 10, further comprising:
a step (IV) of removing the protective layer 1 from the laminate 3.

13. The method for producing a laminate according to claim 7, 9, or 11, further comprising:
a step (IV') of removing the laser-absorbing temporary adhesive layer 1 and the the protective layer 1 from the laminate 4.

14. A method for producing a semiconductor device, comprising:
a step (V) of causing a surface of the laminate obtained by the method for producing a laminate according to claim 12 on the semiconductor layer 1 side to face a surface of a circuit substrate on which a circuit is formed, and bonding the semiconductor layer 1 in the laminate to the circuit substrate by thermocompression-bonding.

15. The method for producing a semiconductor device according to claim 14, further comprising:
after the step (V), a step (VI) of removing a pressure-sensitive adhesive layer-attached support substrate 2 from a structure in which the semiconductor layer 1 in the laminate is bonded to the circuit substrate.

16. The method for producing a semiconductor device according to claim 14, wherein the semiconductor device is a silicon photonic semiconductor device.

17. A laminate comprising:
a support substrate 2, a pressure-sensitive adhesive layer, a semiconductor layer 1, and a protective layer 1 laminated in this order, wherein
the pressure-sensitive adhesive layer has a patterned shape.
